(19) Europäisches Patentamt
European Patent Office
Office européen des brevets

(11) **EP 3 404 780 A1**

(12) **EUROPÄISCHE PATENTANMELDUNG**

(43) Veröffentlichungstag:
**21.11.2018 Patentblatt 2018/47**

(51) Int Cl.:
*H01S 5/062* (2006.01)          *H01S 5/00* (2006.01)
*H01S 5/042* (2006.01)          *H01S 5/06* (2006.01)
*H01S 5/183* (2006.01)

(21) Anmeldenummer: **17000826.2**

(22) Anmeldetag: **15.05.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Universität Konstanz**
**78464 Konstanz (DE)**

(72) Erfinder:
• **LEITENSTORFER, Alfred**
  **78465 Konstanz (DE)**
• **BECKH, Cornelius**
  **78464 Konstanz (DE)**
• **EGGERT, Stefan**
  **78467 Konstanz (DE)**

(74) Vertreter: **Müller-Boré & Partner**
**Patentanwälte PartG mbB**
**Friedenheimer Brücke 21**
**80639 München (DE)**

(54) **LASERDIODE MIT EINEM VORBESTIMMTEN CHIRP**

(57)     Verfahren zum Erzeugen eines optischen Impulses (2) mit einem vorbestimmten Chirp, umfassend Anlegen eines elektrischen Impulses (10) mit einer vorbestimmten Impulsdauer an eine Laserdiode (1), insbesondere einen Oberflächenemitter (1), VCSEL, so dass sich während der Impulsdauer des elektrischen Impulses (10) die Temperatur zumindest eines optisch aktiven Mediums (3) der Laserdiode (1) verändert, wodurch sich während der Impulsdauer des elektrischen Impulses (10) ein Wellenlängenspektrum, insbesondere eine instantane Wellenlänge der von der Laserdiode (1) emittierten elektromagnetischen Strahlung (2) zeitlich ändert.

Figur 2

**Beschreibung**

Die Erfindung betrifft ein Verfahren zur Erzeugung von kurzen, insbesondere ultrakurzen Laserimpulsen, im Folgenden auch optische Impulse oder elektromagnetische Impulse genannt. Zur Erzeugung ultrakurzer und intensiver Laserimpulse werden zunächst entsprechend dem erfindungsgemäßen Verfahren Laserimpulse mit einem vorbestimmten, genau definierten sogenannten Chirp erzeugt. Das erfindungsgemäße Verfahren macht es möglich, gänzlich auf eine Modenkopplung, wie sie typischerweise in einem Resonator umgesetzt wird, zu verzichten.

Ferner betrifft die Erfindung eine Laserdiode, insbesondere einen oberflächenemittierenden Halbleiterlaser, auch Oberflächenemitter bzw. vertical-cavity surface-emitting laser (im Folgenden VCSEL) genannt, die zur Erzeugung kurzer oder ultrakurzer Laserimpulse mit einem vorbestimmten Chirp dient.

Überdies wird ein erfindungsgemäßes System bzw. Lasersystem offenbart, welches die zuvor erwähnte erfindungsgemäße Laserdiode umfasst und zur Erzeugung ultrakurzer intensiver Laserimpulse dient.

Insbesondere betrifft die Erfindung eine spektrale optische Phasenmodulation durch Energieeintrag (Engl.: spectral chirping by energy injection), was im Folgenden auch als "intrinsischer Chirp" bezeichnet wird. Der Begriff "intrinsischer Chirp" kann auch so verstanden werden, dass der Laserimpuls bereits bei der Erzeugung durch einen Energieeintrag einen Chirp aufweist und kein dispersives Medium zur Generierung eines Chirps von dem Laserimpuls passiert werden muss. Die direkte Erzeugung eines zeitlich gestreckten Laserimpulses mit kontinuierlich variierender instantaner Frequenz, der also einen intrinsischen Chirp aufweist, kann dabei Methoden des konventionellen Impulsstreckens ersetzen. Ferner kann eine genaue Phasenlage des erzeugten Laserimpulses durch die Form eines elektrischen Impulses bzw. eines elektrischen Pumpimpulses beeinflusst werden, was z.B. zur genauen Anpassung an das Dispersionsprofil eines Kompressorelementes oder zur Erzeugung beliebiger Impulsformen dienen kann. Insbesondere erlaubt die Erfindung eine direkte Erzeugung eines vorzugsweise breitbandigen, kohärenten Lichtimpulses bzw. Laserimpulses auf eine rein optisch-elektronische Art, ohne die Notwendigkeit eines modengekoppelten Laseroszillators. Daraus resultiert zudem die Möglichkeit zur Bereitstellung dieser Laserimpulse auf besondere Anforderungen, also wiederum auf rein elektronischem Wege, beispielsweise zu variierenden Repetitionsraten und/oder unregelmäßigen Impulsfolgen.

Das erfindungsgemäße Verfahren erlaubt, ein gegenüber Schwankungen robustes, kosteneffizientes Lasersystem mit geringem technischem Aufwand und flexiblen Parametern, insbesondere einer flexiblen Repetitionsrate, zu verwirklichen. Auch können unregelmäßige Laserimpulsformen durch variabel einstellbare Amplituden der elektrischen Impulse mittels der Laserdiode erzeugt werden. Somit können Aufgaben eines sogenannten Pulsformers (Engl.: "pulse shaper") zumindest in Teilen durch die Laserdiode ersetzt werden. Die Phasenlage bzw. der Chirp der zu verstärkenden Laserimpulse ist durch Anpassen eines elektrischen Impulses bevorzugt fein justierbar.

Der Begriff "Chirp" beschreibt die Eigenschaft eines optischen Impulses, dessen Frequenz sich zeitlich bzw. sich in dem zeitlichen Verlauf des Impulses ändert. Ein Impuls mit Chirp kann auch als gechirpter Impuls bezeichnet werden. Mit anderen Worten würde ein Detektor, der einen gechirpten Impuls detektiert, zu Beginn des Auftreffens des Impulses auf den Detektor eine andere Frequenz detektieren als gegen Ende. des Auftreffens. So kann beispielsweise eine sogenannte Autokorrelationsmessung, bei der die Interferenz zweier Laserimpulse an einem Detektor aufgenommen wird, zeigen, dass sich die Frequenz eines Impulses über seinen zeitlichen Verlauf ändern würde, falls ein Chirp vorliegt.

Ein optischer Impuls weist dabei einen positiven (negativen) Chirp auf, wenn sich die Frequenz mit der Zeit vergrößert (verkleinert).

Eine konstante Änderung der Frequenz bzw. Wellenlänge pro Zeit wird als linearer Chirp bezeichnet. Im Folgenden wird ein linearer Chirp überwiegend in der Einheit (ns/nm) angegeben und beschreibt damit anschaulich den zeitlichen Abstand den zwei Wellenlängen mit einem Nanometer Differenz, innerhalb eines optischen Impulses, zueinander aufweisen. Diese anschauliche Darstellung bezieht sich im Wesentlichen auf die sogenannte Zeitdomäne, die durch eine Fourier-Transformation in eine Frequenzdomäne überführt werden kann. Die Frequenzdomäne lässt dabei im Wesentlichen lediglich eine andere Darstellung desselben Phänomens zu.

In der Frequenzdomäne entspricht ein linearer Chirp einer quadratischen spektralen Phase. Ein optischer Impuls mit einer konstanten spektralen Phase besitzt keinen Chirp, er weist dann die kleinstmögliche Dauer, die sein Spektrum erlaubt, auf. Diese Impulsdauer wird meist als Fourier-Limit/Transformationslimit bezeichnet.

Gewöhnlich wird ein optischer Impuls "gechirpt" wenn dieser ein optisch aktives Medium passiert und sich die spektrale Phase des Impulses auf Grund der Dispersion des Mediums verändert. Gemäß der Erfindung weist ein von der Diode emittierter Impuls bereits einen Chirp auf, weshalb dieser zur Unterscheidung der Entstehung auch als "intrinsischer Chirp" bezeichnet wird.

Ein Laserimpuls mit Chirp und dessen damit einhergehende zeitliche Streckung ist regelmäßig erwünscht, insbesondere wenn die Spitzenleistung eines Laserimpulses, also ein vergleichsweise hoher Energiewert, den ein Laserimpuls während eines sehr kurzen Zeitintervalls aufweist, vor Durchlaufen sensibler Elemente, wie beispielsweise eines optischen Verstärkers, reduziert werden soll, um Schäden und unerwünschte optische Effekte zu vermeiden.

Der generelle Begriff der "Leistung" eines optischen Impulses bezieht sich auf die mittlere Leistung bzw. auf die Energie, die ein optischer Impuls über seine zeitliche Dauer aufweist und abgeben könnte. Die Energie ist dabei zeitlich über die Dauer eines optischen Impulses unter Umständen nicht gleich verteilt. In einem bestimmten Zeitintervall kann ein optischer Impuls beispielsweise mehr Energie haben als in einem anderen Zeitintervall innerhalb seines zeitlichen Verlaufs. So kann ein optischer Impuls beispielsweise eine Spitzenleistung aufweisen, bei der in einem Zeitintervall besonders hohe Energiewerte abgegeben werden können.

Solche Spitzenleistungen können bei einer optischen zeitlichen Kompression eines optischen Impulses um ein Vielfaches erhöht bzw. verstärkt werden, wohingegen bei einer optischen zeitlichen Streckung solche Spitzenleistungen abgeschwächt werden können.

Die Intensität bzw. Spitzenintensität eines optischen Impulses, die mit der Leistung bzw. die Spitzenleistung zusammenhängt, ist nicht nur abhängig von der Impulsdauer bzw. zeitlichen Ausdehnung, sondern auch von der räumlichen Ausdehnung des optischen Impulses. Nichtlineare Effekte können insbesondere dann auftreten, wenn ein optischer Impuls eine hohe Spitzenintensität und Spitzenleistung in einem optischen Element, beispielsweise in einer optischen Faser aufweist.

In konventionellen Systemen wird ein Laserimpuls im Wesentlichen dadurch gechirpt, dass der optische Impuls eine optische Anordnung beispielsweise umfassend optische Gitter und Spiegel (beispielsweise in einem sogenannten Stretcher) passiert. Dabei nutzt man die dispersiven Eigenschaften optischer Elemente (beispielsweise optischer Gitter oder Prismen), um ein Wellenlängenspektrum örtlich "aufzufächern" bzw. Wellenlängen örtlich zu trennen und, über unterschiedliche Weglängen für unterschiedliche Wellenlängen, einen Chirp zu erzeugen.

In vielen Bereichen, wie z.B. im medizinischen Bereich, in Wissenschaft und Forschung, sowie in der Industrie insbesondere bei Fertigungsprozessen besteht eine hohe Nachfrage an Lasersystemen, welche (ultra-) kurze und intensive Laserimpulse erzeugen. Insbesondere die Felder der Laserspektroskopie / Kurzzeitspektroskopie, Mikroskopie, Medizintechnik und/oder Lasermaterialbearbeitung stellen stetig neue Anforderungen an Lasersysteme, beispielsweise betreffend die Effizienz eines Lasersystems, dessen Kosteneffizienz, dessen Wartungsumfang, sowie dessen Flexibilität.

Das konventionelle Konzept zur Erzeugung ultrakurzer und intensiver optischer Impulse bzw. Laserimpulse basiert bisher in der Regel auf modengekoppelten Laseroszillatoren. Diese emittieren einen meist breitbandigen Laserimpuls, dessen Repetitions- bzw. Wiederholrate(n) durch die Resonator-Umlaufdauer zumeist weitestgehend festgelegt ist. Für die Erzeugung von Laserimpulsen mit hohen Energien ist danach typischerweise eine Einzelimpulsverstärkung in einem Verstärkerelement notwendig. Zur Vermeidung besonders hoher Spitzenleistungen insbesondere vor dem Durchlaufen des Verstärkerelements eines optischen Laserimpulses werden einzelne Laserimpulse isoliert und zeitlich gestreckt. Danach werden diese Laserimpulse verstärkt und zeitlich wieder komprimiert. Konventionelle Verfahren unterliegen deshalb in den meisten Fällen dem Prinzip der "Chirped Pulse Amplification" (kurz CA).

Der Begriff "Resonator" kann auch durch die Begriffe "optische Kavität" und/oder "Resonatorkavität" beschrieben und verstanden werden. Der Resonator, insbesondere der Resonator einer (Halbleiter-)Laserdiode, insbesondere eines VCSEL umfasst in der Regel zwei Resonatorspiegel bzw. Spiegel, insbesondere Bragg-Schicht-Reflektoren und ein optisch aktives Medium bzw. Element. Die Spiegel des Resonators sind derart angeordnet, dass zwischen den Spiegeln das optisch aktive Element des Resonators angeordnet ist. Elektromagnetische Strahlung wird derart in dem Resonator von einem der Spiegel zu dem anderen der Spiegel reflektiert, dass das optisch aktive Medium jeweils von der reflektierten elektromagnetischen Strahlung passiert wird. Der Resonator kann neben den genannten Elementen, nämlich den Spiegeln und dem optisch aktiven Element, auch andere Elemente und/oder Medien umfassen. Beispielsweise kann es in dem Resonator auch einen Luftspalt und/oder eine Beschichtung geben.

Gemäß einem Aspekt besteht eine der vorliegenden Erfindung zugrunde liegende Aufgabe in der Möglichkeit der effizienten Erzeugung von kurzen, insbesondere ultrakurzen Laserimpulsen.

Diese Aufgabe wird durch ein Verfahren, eine Laserdiode und ein System gemäß der unabhängigen Ansprüche gelöst. Bevorzugte Ausführungsformen sind Gegenstand der abhängigen Ansprüche.

Ein Aspekt der Erfindung betrifft ein Verfahren zum Erzeugen eines optischen Impulses mit einem vorbestimmten, insbesondere einem präzise definierten Chirp, umfassend ein Anlegen eines elektrischen Impulses mit einer vorbestimmten Impulsdauer und/oder einer vorbestimmten Impulsform an eine Laserdiode, insbesondere einen Oberflächenemitter, VCSEL, so dass sich während der Impulsdauer des elektrischen Impulses die Temperatur zumindest eines Elements eines Resonators der Laserdiode verändert, wodurch sich während der Impulsdauer des elektrischen Impulses ein Wellenlängenspektrum, insbesondere eine instantane Wellenlänge der von der Laserdiode, insbesondere von dem optisch aktiven Medium bzw. einem optisch aktiven Bereich emittierten elektromagnetischen Strahlung zeitlich ändert.

In anderen Worten betrifft ein Aspekt der Erfindung ein Verfahren zum Erzeugen eines optischen Impulses mit einem genau definierten Chirp, umfassend ein Anlegen eines elektrischen Impulses mit einer vorbestimmten Impulsform an eine Laserdiode, insbesondere einen Oberflächenemitter, VCSEL, so dass sich während der Impulsdauer des elektrischen Impulses die Temperatur zumindest eines Elements eines Resonators der Laserdiode verändert, wodurch sich während der Impulsdauer des elektrischen Impulses die emittierte instantane Wellenlänge der Laserdiode bzw. die instantane Wellenlänge der von der Laserdiode emittierten Strahlung zeitlich ändert, sodass ein optischer Impuls mit verbreitertem Spektrum erzeugt wird. In anderen Worten gesagt kann sich während der Impulsdauer des elektrischen Impulses die Zentralwellenlänge der von dem optisch aktiven Medium emittierten elektromagnetischen Strahlung zeitlich ändern und somit kann von der Laserdiode, insbesondere dem optisch aktiven Bereich, beispielsweise von dem optisch aktiven Medium ein optischer Impuls mit verbreitertem Spektrum emittiert werden.

In anderen Worten ändert sich zeitlich die instantane bzw. augenblickliche Wellenlänge eines von der Laserdiode emittierten optischen Impulses während der Impulsdauer des elektrischen Impulses. Als Folge entsteht bzw. liegt ein optischer Impuls mit verbreitertem Spektrum vor. Der Begriff "instantane Wellenlänge" kann in einer Näherung als ein diskreter Wert verstanden werden, betrifft im Detail genauer die Zentralwellenlänge bzw. die zentrale Wellenlänge eines Wellenlängenbereichs innerhalb einer natürlichen Linienbreite eines optischen Impulses, der von einem optisch aktiven Medium bzw. einer Laserdiode zu einem Zeitpunkt emittiert wird.

Eine Laserdiode, insbesondere ein Oberflächenemitter bzw. VCSEL ist dazu ausgelegt elektromagnetische Strahlung zu emittieren. Die Laserdiode umfasst einen optisch aktiven Bereich, umfassend einen Resonator und ein optisch aktives Medium. Die elektromagnetische Strahlung wird innerhalb des optisch aktiven Bereichs, insbesondere innerhalb des Resonators und/oder insbesondere innerhalb des optisch aktiven Mediums, welches ein Halbleitermaterial sein kann, erzeugt. Deshalb wird elektromagnetische Strahlung von einer Laserdiode, insbesondere einem Resonator, besonders einem optisch aktiven Bereich und bevorzugt von einem optisch aktiven Medium emittiert.

Gemäß einer bevorzugten Ausführungsform ändert sich die Temperatur mindestens eines Spiegels, bevorzugt zweier Spiegel, insbesondere zweier Bragg-Schichtungen des Resonators. Ein Spiegel kann auch als Reflektor bezeichnet und/oder verstanden werden. Ein Bragg-Schicht-Reflektor umfasst eine Bragg-Schichtung mit einer Mehrzahl von Bragg-Schichten.

Gemäß einer bevorzugten Ausführungsform ändert sich zeitlich während der Zeitdauer bzw. Impulsdauer des elektrischen Impulses ein Wellenlängenspektrum der von dem optisch aktiven Bereich, insbesondere der von dem optisch aktiven Medium und/oder der von dem Resonator emittierten elektromagnetischen Strahlung. In anderen Worten kann bzw. können ein optisch aktiver Bereich, insbesondere ein optisch aktives Medium und/oder ein Resonator optische Impulse emittieren, welche einen Chirp aufweisen. Dahingehend weisen diese optischen Impulse eine sich zeitlich ändernde instantane bzw. instantan- bzw. augenblicklich-emittierte Wellenlänge auf.

In anderen Worten kann bzw. können eine Laserdiode, insbesondere ein optisch aktiver Bereich, bevorzugt ein optisch aktives Medium und/oder ein Resonator einen optischen Impuls emittieren, welcher ein Wellenlängenspektrum aufweist, das sich zeitlich während der Zeitdauer bzw. Impulsdauer des elektrischen Impulses ändert. Gemäß einer bevorzugten Ausführungsform ändert sich die Temperatur eines Elements bzw. Abschnitts des Resonators derart, dass sich eine optische Weglänge zwischen zwei Spiegeln des Resonators ändert. Die optische Weglänge betrifft zum Beispiel den Weg, den eine elektromagnetische Strahlung bzw. ein optischer Impuls zwischen zwei Spiegeln durch das optisch aktive Medium zurücklegen muss.

Gemäß einer bevorzugten Ausführungsform ändert sich die Temperatur eines optisch aktiven Mediums zwischen zwei Spiegeln des Resonators.

In anderen Worten kann sich die Temperatur eines Spiegels oder zweier Spiegel bzw. Reflektoren, insbesondere eines Bragg-Schicht-Reflektors, einer Bragg-Schichtung und/oder einer oder mehrerer Bragg-Schichten des Resonators ändern. Zusätzlich oder alternativ kann sich die Temperatur eines optischen Elementes, insbesondere des optisch aktiven Mediums des Resonators ändern. Zusätzlich oder alternativ kann sich die Temperatur des gesamten Resonators ändern. Zusätzlich oder alternativ kann sich die Temperatur eines anderen Elementes und/oder eine Luftschicht und/oder eine Füllung, d.h. eines weiteren Mediums innerhalb des Resonators ändern. Ferner kann es auch sein, dass sich die genannten Elemente nur bereichsweise ändern. Dabei kann sich die Temperatur der Spiegel gleichermaßen mit oder unterschiedlich zu der Temperatur des optisch aktiven Mediums ändern. Ferner können sich auch Temperaturen anderer optionaler externer Elemente, beispielsweise von Haltevorrichtungen ändern. Eine Temperaturänderung eines jeweiligen Abschnitts und/oder Elements kann zu einer Änderung seiner räumlichen Ausdehnung führen.

Beispielsweise kann eine Änderung in der räumlichen Ausdehnung dazu führen, dass sich die Resonatoreigenschaften, insbesondere die Resonatorbedingung ändert. Dies kann dazu führen, dass sich die Wellenläng(en), die die Resonatorbedingung erfüllt bzw. erfüllen während des zeitlichen Verlaufs der Erwärmung ändert.

Das erfindungsgemäße Verfahren erlaubt, mit Hilfe einer Laserdiode und deren optisch aktiven Medium durch Hindurchleiten eines Stromimpulses, einen Laserimpuls mit einem vorbestimmten intrinsischen Chirp zu erzeugen. Die Erfindung betrifft also eine spektrale optische Phasenmodulation durch Energieeintrag (Engl.: spectral chirping by energy injection). Dazu wird eine zeitliche Temperaturerhöhung zumindest eines Elementes des Resonators bzw. der Resonatorkavität über die Impulsdauer eines elektrischen Impulses erzielt. Die Laserdiode erzeugt bei unterschiedlichen statischen Temperaturen, also im Gleichgewicht, Wellenlängenspektren mit unterschiedlichen Frequenz- bzw. Wellenlängenanteilen bzw. mit unterschiedlichen zentralen Wellenlängen. Eine zentrale Wellenlänge ist die mittlere Wellenlänge eines Wellenlängenbereichs. Deshalb entsteht auch bei einer Temperaturerhöhung, insbesondere einer kontinuierlichen Temperaturerhöhung, ein gegenüber einem statischen Spektrum, also einem Spektrum, das ohne Temperaturänderung erzeugt wird, verbreitertes Wellenlängenspektrum. Dieses Wellenlängenspektrum kann im Wesentlichen Wellenlängenanteile umfassen, welche bei den jeweiligen Temperaturen, die die Laserdiode während der Erwärmung annimmt, auch im statischen Zustand zu den jeweiligen Temperaturen erzeugt werden würden.

Das Spektrum des von einer Laserdiode emittierten optischen Impulses einer sich erwärmenden Laserdiode ist also verbreitert gegenüber dem Spektrum eines Impulses einer sich nicht-erwärmenden Laserdiode. Somit kann das Spektrum des Impulses der erfindungsgemäßen Laserdiode mehr Wellenlängen gegenüber dem Spektrum einer Laserdiode umfassen, die sich zu einer bestimmten Temperatur im thermischen Gleichgewicht befindet, also im Wesentlichen keine Temperaturänderung erfährt. Somit werden sich kontinuierlich ändernde Wellenlängen bzw. Wellenlängenanteile über den Zeitraum der Anregung des optischen Mediums und der damit einhergehenden zeitlichen Erwärmung der Laserdiode emittiert. Der emittierte Laserimpuls umfasst dann Wellenlängen, die im zeitlichen Verlauf des Laserimpulses gegeneinander verschoben sind. In anderen Worten erreicht eine Wellenlänge gegenüber einer anderen davon abweichenden Wellenlänge innerhalb eines einzigen Laserimpulses ihr "Ziel" auf einer Wegstrecke früher. Der Laserimpuls ist demnach intrinsisch "gechirpt". Der Chirp ist entsprechend ein Maß dafür, wie groß in einem Laserimpuls eine zeitliche Differenz zweier Wellenlängen gegenüber einander ist.

Vorteilhafterweise ermöglicht das erfindungsgemäße Verfahren, einen Laserimpuls bereitzustellen, der intrinsisch einen Chirp aufweist. Somit kann auf eine Verwendung von dispersiven Elementen zum Erzeugen eines Chirps, insbesondere zur Verringerung von Spitzenleistungen und Intensitäten verzichtet werden. In anderen Worten weist der von der erfindungsgemäßen Laserdiode emittierte Laserimpuls bereits einen Chirp auf. Auch können im Anschluss an die Laserdiode weitere optische Elemente im Strahlengang vorhanden sein, die den Laserimpuls beeinflussen bzw. verändern, insbesondere verstärken. Optische Elemente zum Erzeugen des Chirp besonders zur Verringerung der Leistungsspitzen bzw. Spitzenleistung(en) des Laserimpulses können dann im bevorzugten Fall überflüssig sein. Ein besonderer Vorteil liegt darin, dass der Chirp aufgrund des elektrischen Stromflusses durch die Laserdiode und der daraus resultierenden Erwärmung der Laserdiode, insbesondere der Erwärmung des optisch aktiven Bereiches und besonders des Resonators erzeugt wird und deswegen innerhalb bzw. im nahen Umfeld der Laserdiode stattfindet. Daher kann das erfindungsgemäße Verfahren besonders platzsparend und kosteneffizient sein. Das Verfahren erfordert hinsichtlich des Erzeugens des Chirps im Wesentlichen keinen oder - wenn überhaupt - nur einen geringen Wartungsaufwand.

Ebenso kann der Chirp in einfacher Weise gesteuert und/oder geregelt werden, und zwar mittels der Steuerung und/oder der Regelung des elektrischen Impulses bzw. Pumpimpulses, der an der Laserdiode anliegt.

Es kann ferner vorteilhaft sein, einen Laserimpuls mit einem vorbestimmten Chirp zu erzeugen, wenn der Laserimpuls in einem Strahlengang optische Elemente mit einer materialabhängigen Dispersion, beispielsweise einer chromatischen Dispersion, durchläuft, die eine Phasengeschwindigkeitsdispersion hervorrufen, was wiederrum zu einem weiteren Chirp, bzw. einer Kompression oder einer Streckung in dem Laserimpuls führt. In solchen optischen Medien gibt es in der Regel einen frequenzabhängigen Brechungsindex, der dazu führt, dass verschiedene Wellenlängen verschieden schnell durch das optische Element bzw. Medium laufen, was Phasengeschwindigkeitsdispersion genannt wird und entsprechend zu einem Chirp führt. Derart kann der dispersive Effekt und damit verbundene Chirp, den der optische Impuls durch das optische Element erhält von vornherein durch einen entgegengesetzten intrinsischen Chirp des emittierten Laserimpulses praktisch und einfach kompensiert werden.

Ferner erweist sich das erfindungsgemäße Verfahren, insbesondere falls die Laserdiode ein Oberflächenemitter, d.h. ein VCSEL ist, als besonders kosteneffizient. Ein Oberflächenemitter bzw. VCSEL emittiert elektromagnetische Strahlung überwiegend senkrecht zu einer Ebene des Halbleiterchips, im Gegensatz zu herkömmlichen Kantenemittern, die die elektromagnetische Strahlung überwiegend an ein oder zwei Flanken bzw. Kanten des Chips emittieren. Oberflächenemitter haben den Vorteil besonders geringer Herstellungskosten und eines weitestgehend geringen Stromverbrauchs. Ein weiterer Vorteil eines VCSEL besteht darin, dass er monomodig betrieben werden kann, also Licht bzw. elektromagnetische Strahlung mit überwiegend einer Mode emittieren kann. Der Oberflächenemitter kann zudem auch ein Abstimmen bzw. Verstellen bzw. Einstellen der Wellenlänge des emittierten Laserimpulses erlauben. Allgemein kann durch einen VCSEL auch eine hohe Einkoppeleffizienz in Lichtwellenleiter erzielt werden.

Optische Impulse sind elektromagnetische Impulse, die in aller Regel von Lasern erzeugt und mit einem Laserstrahl übertragen werden. Deshalb werden diese optischen Impulse auch Laserimpulse genannt. Optische Impulse haben eine besonders kurze Dauer. Diese Impulszeiten resultieren aus Bandbreitewerten im Terahertz-Bereich, wie sie von Monomodefasern unterstützt werden. Es sei explizit erwähnt, dass sich das Spektrum der Laserimpulse nicht auf das sichtbare Spektrum begrenzt. Es ist hier zwischen den Laserimpulsen zu unterscheiden, die eine Laserdiode emittieren kann und denen, die ein System, umfassend eine Laserdiode, ein Verstärkermedium und ein Kompressor, emittieren kann. Die von einem derartigen System emittierten optischen Impulse bzw. Laserimpulse können vorzugsweise eine Dauer von weniger als 4 ps, insbesondere weniger als 1 ps, besonders weniger als 800 fs haben. Es kann auch sein, dass die von dem System erzeugten Laserimpulse eine zeitliche Dauer von 400-500 fs haben. Die von einer Laserdiode emittierten optischen Impulse bzw. Laserimpulse können bevorzugt eine Dauer von wenigen Nanosekunden, insbesondere zwischen 1 und 20 ns haben. Insbesondere ist der elektromagnetische Impuls bzw. Laserimpuls nicht mit einem elektrischen Impuls zu verwechseln, der an eine Laserdiode angelegt werden kann, um einen elektromagnetischen Impuls zu erzeugen.

Bevorzugt und optional umfasst das Verfahren ferner einen Schritt der Selektion eines vorbestimmten spektralen Wellenlängenbereichs, der während der Impulsdauer des elektrischen Impulses von dem optisch aktiven Medium emittiert wird.

Es kann in vielen Fällen vorteilhaft sein, nur einen vorbestimmten Bereich aus dem Wellenlängenspektrum eines von der Laserdiode emittierten optischen Impulses zu selektieren bzw. "herauszuschneiden" bzw. für weitere Schritte passieren zu lassen.

Vorteilhafterweise können vorbestimmte Wellenlängen, die z.B. für weitere Schritte verwendet werden sollen, selektiert werden. Alternativ oder zusätzlich können Wellenlängen, die beispielsweise Intensitätsspitze(n) bzw. Peak(s) bzw. überhöhte Intensität(en) aufweisen und wegen einer überhöhten Energie eines bestimmten Wellenlängenbereichs unerwünscht sind, aus dem Wellenlängenspektrum des optischen Impulses entfernt werden. Dies bedeutet, dass lediglich diejenigen Wellenlängenanteile im optischen Impuls verbleiben, die diese(n) Peak(s) bzw. überhöhte Intensität(en) nicht aufweisen.

Beispielsweise kann durch Selektion eines bestimmten Wellenlängenbereichs der optische Impuls auch "geformt" werden. Wie bereits erwähnt, kann über die Fourier-Transformation der Zeitbereich, d.h. die "time domain" in den Frequenzbereich, d.h. die "frequency domain" übersetzt bzw. transformiert werden. Eine Manipulation im Frequenzbereich bewirkt deshalb eine Änderung im Zeitbereich. Derart können über Änderungen der spektralen Form bzw. des Spektrums gezielt einzelne oder Gruppen von optischen Impulsen zeitlich geformt bzw. manipuliert werden. Typischerweise erfolgt ein Formen eines optischen Impulses über einen sogenannten "pulse shaper", der beispielsweise über dispersive optische Elemente eine Manipulation im Wellenlängenbereich zulässt, um eine gezielte Impulsform bzgl. des Zeitbereiches bzw. einen zeitlichen Intensitätsverlauf zu erzielen.

Aus dem zuvor genannten Grund ist der folgende optionale Schritt in dem Verfahren besonders bevorzugt: Ausschluss eines Wellenlängenbereichs des Wellenlängenspektrums des von der Laserdiode emittierten optischen Impulses aus dem vorbestimmten selektierten Wellenlängenbereich, wobei der ausgeschlossene Wellenlängenbereich mindestens eine überhöhte Intensität aufweist, die wesentlich von den Intensitäten anderer Wellenlängen abweicht, bevorzugt aber nicht unbedingt betrifft der ausgeschlossene Wellenlängenbereich dabei einen Bereich niedriger bzw. kurzer bzw. kürzerer Wellenlängen in dem Wellenlängenspektrum des von dem optisch aktiven Medium emittierten optischen Impulses.

Dabei kann der optionale Schritt der Selektion vor und/oder nach einem Schritt des Verstärkens oder während dem Schritt der Kompression stattfinden.

Die spektrale Selektion eines Wellenlängenbereichs vor einer Verstärkung kann in diesem bevorzugten Schritt insbesondere dazu genutzt werden, um möglicherweise unerwünschte Bereiche im Frequenz- bzw. Wellenlängenspektrum mit besonders hohen bzw. überhöhten Intensitäten und entsprechend hohen Energien, "herauszuschneiden" bzw. herauszufiltern bzw. aus dem selektierten Bereich auszuschließen bzw. zu unterdrücken. Solche überhöhten Intensitäten, die es in vielen Fällen zu vermeiden gilt, können beispielsweise zu unerwünschten Effekten innerhalb eines Verstärkermediums führen.

Die optionale Selektion eines vorbestimmten Wellenlängenbereichs nach einem Verstärken kann beispielsweise auch dazu dienen, Intensitäten in einem Wellenlängenbereich herauszufiltern, die überwiegend durch spontane Emission, insbesondere verstärkte spontane Emission erzeugt werden.

Weiter bevorzugt und optional erfolgt die optionale Selektion mittels eines Faser-Bragg-Gitters, insbesondere eines gechirpten bzw. frequenzmodulierten Faser-Bragg-Gitters. Eine Selektion kann auch während einer Kompression innerhalb eines selben gechirpten Faser-Bragg-Gitters stattfinden.

Der Begriff des "gechirpten Faser-Bragg-Gitters" (Engl.: chirped fiber Bragg-grating) bezieht sich auf die Fähigkeit eines Faser-Bragg-Gitters, einen Laserpuls, insbesondere dispersiv chirpen zu können.

Durch die optionale Verwendung eines gechirpten Faser-Bragg-Gitters zur spektralen Selektion kann beispielsweise auf andere optische, beispielsweise dispersive Elemente und/oder Anordnungen, wie zum Beispiel "pulse shaper" verzichtet werden. Dies hat den Vorteil, kosten- und wartungseffizient zu sein.

Die optionale Verwendung eines gechirpten Faser-Bragg-Gitters zur Selektion eines spektralen Wellenlängenbereichs bringt die Vorteile eines Faser-basierten bzw. Lichtleiter-basierten Systems mit sich. Insbesondere gechirpte Volumen-Bragg-Gitter ermöglichen darüber hinaus auch eine Kompression von optischen Impulsen mit höheren bzw. besonders hohen Impulsenergien, da dadurch ein größerer örtlicher Durchmesser des Laserstrahls ermöglicht und entsprechend geringere Intensitäten des Laserimpulses ermöglicht werden. Ein gechirptes Volumen-Bragg-Gitter umfasst ein sogenanntes "Freistrahl-Element", was typischerweise mit Spiegeln betrieben wird. Ultrakurze optische Impulse mit hohen Impulsenergien werden insbesondere in Systemen umfassend ein gechirptes Volumen-Bragg-Gitter erzeugt. Auch erweist sich die Justage eines gechirpten Volumen-Bragg-Gitters als besonders einfach und effizient verglichen mit Gitter- und/oder Prismen-Anordnungen.

Die Wahl eines Faser-basierten bzw. Lichtleiter-basierten Systems kann sich als vorteilhaft erweisen, da Licht bzw. elektromagnetische Strahlung durch die innere Mehrfachreflexion eines Lichtleiters "um Ecken" geleitet werden kann, ohne dass zusätzliche optische Elemente benötigt werden. Dies hat einerseits den Vorteil, dass ein kompakter Strahlengang angestrebt werden kann und andererseits ein geringer Aufwand bezüglich der Justage des Strahlengangs erfordert wird. Die Einsparung von optischen Elementen, Justage-Zeit und der kompaktere Aufbau können gemeinsam zu einer Kosteneinsparung führen.

Besonders die Kombination aus Faser-basierten Elementen und einem Oberflächenemitter erweist sich als vorteilhaft, da Oberflächenemitter eine besonders hohe Einkoppeleffizienz in (Licht-) Wellenleiter aufweisen.

Optional und bevorzugt beträgt der Chirp des durch eine erfindungsgemäße Laserdiode emittierten optischen Impulses zwischen 50 ps/nm und 20 ns/nm, insbesondere zwischen 500 ps/nm und 10 ns/nm und darin bevorzugt zwischen 1 ns/nm und 5 ns/nm. Bevorzugt kann ein negativer Chirp erzielt werden, wobei die Werte in ns oder ps/nm ein positives Vorzeichen aufweisen. Alternativ kann auch ein positiver Chirp erzeugt werden.

Der bevorzugte Bereich von Werten, den ein Chirp annehmen kann, eignet sich besonders zur Kompensation eines Chirps, der durch häufig verwendete bzw. übliche dispersive Elemente erzeugt wird, die im Strahlengang der Laserdiode anordenbar sind.

Optional und bevorzugt entspricht die Impulsdauer des optischen Impulses, wie er von der Laserdiode emittiert wird, im Wesentlichen, bevorzugt genau der Impulsdauer des elektrischen Impulses. Die Impulsdauer kann zwischen 1 und 30 ns, insbesondere zwischen 3 und 20 ns und besonders bevorzugt zwischen 6 und 14 ns betragen.

Ein Verfahren, das optional eine Laserdiode voraussetzt, deren elektrische Eigenschaften es erlauben, dass ein angelegter elektrischer Impuls im Wesentlichen dieselbe Impulsdauer aufweist, wie die des emittierten optischen Impulses und wobei optional im Wesentlichen keine nennenswerte Verzögerung zwischen dem Verlauf auftritt, ist dahingehend vorteilhaft, dass sich in einfacher Weise der optische Impuls berechnen bzw. planen und/oder kontrollieren und/oder steuern und/oder regeln lässt. Die Impulsdauer ist vorteilhafterweise direkt von dem elektrischen Impuls auf den optischen Impuls übertragbar.

Die Impulsdauer zwischen 1 und 30 ns für den elektrischen und den optischen Impuls erweist sich als besonders günstig für das bevorzugte Maß des Chirps und des Wellenlängenspektrums eines von einer Laserdiode emittierten optischen Impulses.

Optional und bevorzugt entspricht die Repetitionsrate des optischen Impulses im Wesentlichen einer Repetitionsrate des elektrischen Impulses, wobei die Repetitionsrate zwischen 1 kHz und 100 MHz, insbesondere zwischen 10 kHz und 10 MHz, bevorzugt zwischen 50 kHz und 1 MHz beträgt.

Ähnlich wie im Fall der Impulsdauer ist es für die Kontrolle und die Berechnung bzw. Vorbestimmung eines optischen Impulses vorteilhaft, wenn eine Repetitionsrate des elektrischen Impulses im Wesentlichen der des optischen Impulses entspricht. Da der elektrische Impuls verwendet wird, um die Laserdiode zu betreiben, entspricht die Impulsdauer des optischen Impulses im Wesentlichen der Impulsdauer des elektrischen Impulses. Ebenso kann die Impulshöhe des elektrischen Impulses, d.h. die Stromstärke und/oder die Spannung des elektrischen Impulses ein Maß für die Intensität des optischen Impulses sein. Da die Temperaturerhöhung der Laserdiode im Wesentlichen dem elektrischen Impuls folgt, ist somit auch der Chirp des optischen Impulses mittels des elektrischen Impulses steuer- und/oder regelbar.

Der angegebene bevorzugte Bereich für die Repetitionsrate ist ein Bereich, der üblicherweise im Wesentlichen auch von konventionellen Lasersystemen angesteuert wird, deshalb ist es vorteilhaft denselben Bereich an Repetitionsraten zu ermöglichen.

Ferner ist es bevorzugt, dass eine Repetitionsrate des optischen Impulses durchstimmbar ist. Ein wesentlicher Vorteil besteht darin, dass beispielsweise die Repetitionsrate nicht etwa von den geometrischen Maßen eines Resonanzkörpers abhängt, sondern von der Repetitionsrate bzw. Frequenz der angelegten elektrischen Impulse. Dies erlaubt eine im Wesentlichen stufenlose Einstellung der Laserimpuls-Repetitionsrate d.h. ein im Wesentlichen stufenloses tuning des optischen Impulses. Ferner können optische Impulse mit "gemischten Frequenzen" erzeugt werden, also unterschiedliche Frequenzanteile haben und/oder in unregelmäßigen Abständen emittiert werden.

Optional und bevorzugt wird mittels des elektrischen Impulses der Chirp des optischen Impulses gesteuert und/oder geregelt, wobei insbesondere optional mittels einer maximalen elektrischen Spannung des elektrischen Impulses und/oder mittels eines zeitlichen Verlaufs der elektrischen Spannung des elektrischen Impulses und/oder mittels der Impulsdauer des elektrischen Impulses der Chirp des optischen Impulses geregelt oder gesteuert wird.

Wie zuvor bereits erwähnt, kann der Chirp eines Laserimpulses vorteilhaft sein, um Spitzenintensitäten bzw. Spitzenleistungen anzupassen und/oder dispersiver Effekte von optischen Elementen zu kompensieren. Die Steuerung und/oder Regelung des Chirps auf ein vorbestimmtes erwünschtes Maß über elektronische durchstimmbare Kontrollparameter, wie maximale elektrische Spannung und/oder Stromstärke, zeitlicher Verlauf und/oder Impulsdauer eines elektrischen Impulses, erlaubt ein besonders hohes Maß an Flexibilität. Optische Elemente mit unterschiedlichen dispersiven Eigenschaften können beispielsweise ausgetauscht, hinzugefügt oder ausgebaut werden und der Chirp des optischen Impulses kann einfach durch Anpassung der elektrischen Kontrollparameter auf den neuen Strahlengang optimal angepasst werden. Es kann ferner darauf verzichtet werden, dispersive Effekte mit zusätzlichen optischen Elementen auszugleichen bzw. zu kompensieren, was mit einem erheblichen Aufwand und Kosten verbunden ist. Deswegen erlaubt ein Verfahren gemäß der vorliegenden Anmeldung mit den genannten optionalen und bevorzugten Schritten ein besonders hohes Maß an Flexibilität, Vielseitigkeit und Vereinfachung einer optischen Impulserzeugung.

Durch das Regeln und/oder Steuern des Chirps eines optischen Impulses durch rein elektronische Parameter kann derart bei Bedarf auch ein elektronischer Pulsgeber zumindest teilweise die typischen Aufgaben eines "pulse shapers" übernehmen.

Optional und bevorzugt umfasst das Verfahren weiter den Schritt: Verstärken des optischen Impulses mittels eines Verstärkers, wobei der optische Impuls an optische Eigenschaften des Verstärkers angepasst ist und/oder Komprimieren des optischen Impulses mittels eines Kompressors, wobei der optische Impuls an optische Eigenschaften des Kompressors angepasst ist.

Das optionale optische Verstärken dient dazu, die Energie des Laserimpulses zu erhöhen, beispielsweise durch die sogenannte stimulierte Emission in einem Lasermedium, bevorzugt in einem Faserverstärker mit Erbium-dotierter Faser, insbesondere in einem Faserverstärker mit Erbium-dotierter Faser für Oberflächenemitter, die im Wellenlängenbereich zwischen 1480 und 1600 nm emittieren, oder in Ytterbium-dotierten Faserverstärkern für Laserdioden, die etwa bei 1030 nm emittieren. Vorteilhaft kann in diesem Fall das Erzeugen eines Laserimpulses mit derart vorbestimmtem Chirp sein, dass der Laserimpuls bei dem Durchlaufen des Verstärkers keine Schäden aufgrund hoher bzw. überhöhter Intensitäten bewirkt.

Es besteht weiter ein Vorteil in der Verwendung von Faserverstärkern, insbesondere von Erbium-, Ytterbium- oder Thulium-dotierten Faserverstärkern. Faserverstärker zählen zu den optischen Verstärkern, welche Laser in ihrer ursprünglichsten Form ohne optischen Resonator darstellen. Im Gegensatz zu regenerativen Verstärkern, welche oft in konventionellen Lasersystemen eingesetzt werden, arbeiten optische Verstärker unabhängig von der Modulation eines optischen Signals (deshalb auch als "transparent" bezeichnet). Wegen des Verzichts auf ein Resonator-basiertes Verstärkerelement werden Repetitionsraten, also die Frequenz, in der optische Impulse abgegeben werden können, zumindest nicht durch eine Geometrie eines Resonators bzw. durch eine Resonatorlänge begrenzt, was ein höheres Maß an Flexibilität möglich macht.

Die Laserdiode bzw. der Oberflächenemitter ist dabei zu Vergleichen mit einem Kurzpulslaser bzw. Kurzpulsoszillator Anregungslaser eines konventionellen Lasersystems, deren bzw. dessen elektromagnetische Strahlung in einem Verstärkermedium insbesondere durch stimulierte Emission verstärkt wird. Vorteilhaft erweist sich ferner das optionale Vorverstärken und Hauptverstärken, also das Verstärken in zwei Schritten, denn zwischen den Schritten kann beispielsweise das Spektrum effektiv manipuliert bzw. aufbereitet werden. Beispielsweise kann es, wie bereits erwähnt, von Vorteil sein, nach einer Vorverstärkung, gewisse Überhöhungen in dem Frequenzspektrum zu erkennen bzw. auszumachen, welche dann vor dem Hauptverstärken "herausgeschnitten" und/oder herausgefiltert werden. Derartige Wellenlängen mit überhöhten Intensitäten könnten beispielsweise zu unerwünschten optischen Effekten zumindest in einem Verstärkermedium führen.

Faser-Bragg-Gitter weisen im Wesentlichen die Vorteile von Faserbauteilen auf und ermöglichen die Kompression von sehr großen Chirp-Werten, beispielsweise von 2 ns/nm und mehr.

Ein weiter Vorteil ergibt sich aus der Verwendung eines Volumen-Bragg-Gitters zur Kompression des (inzwischen) verstärkten und gechirpten Laserimpulses. Das optionale Komprimieren bewirkt, dass der zeitliche Verlauf des von der Laserdiode emittierten optischen Impulses komprimiert und der Chirp weitestgehend verringert und/oder ausgelöscht wird. In anderen Worten wird der bestehende Chirp, der zwar vorteilhaft vor der Verstärkung aber möglicherweise unerwünscht an einem Experiment bzw. zur Verwendung ist, kompensiert bzw. gelöscht. Dies bedeutet, dass dann in der Frequenzdomäne die spektrale Phase des Laserpulses konstant ist. Derart wird bewirkt, dass alle Wellenlängen innerhalb eines optischen Impulses unverzögert zueinander mit derselben Geschwindigkeit, also überwiegend zeitlich und räumlich überlagert, aus einem System emittiert werden. Derart kann ein zeitlich sehr kurzer optischer Impuls erzeugt werden, der für den Fall, dass er verstärkt wurde, eine sehr hohe Intensität bzw. Energiedichte aufweist.

Insbesondere ist es von Vorteil, ein Volumen-Bragg-Gitter als Kompressor zu verwenden, da ein Volumen-Bragg-Gitter in der Lage ist, optische Impulse mit sehr hohen Energien bis zu 2 mJ zu komprimieren. Da es sich um ein Freistrahlbauteil handelt ist der Strahldurchmesser des optischen Impulses flexibel wählbar. Die Länge des Kristalls des Volumen-Bragg-Gitters legt fest, welche zeitlichen Ausdehnungen optischer Impulse komprimiert werden können. Beispielsweise kann ein 10 cm langer Kristall einen optischen Impuls mit 1 ns zeitlicher Ausdehnung komprimieren. Durch Mehrfachreflektion kann ein Vielfaches davon, beispielsweise ein 2 oder 3 ns langer optischer Impuls komprimiert werden.

Gemäß einer bevorzugten Ausführungsform der vorliegenden Erfindung kann auf ein Kompressorelement, beispielsweise umfassend mehrere optische Gitter und Spiegel, welche eine Aufwendige Justage erfordern, verzichtet werden. Ein Volumen-Bragg-Gitter erlaubt zwar nur ein vorbestimmtes Maß einer Kompression von optischen Impulsen, jedoch kann gemäß einer bevorzugten Ausführungsform der vorliegenden Erfindung der Chirp des optischen Impulses an der Laserdiode vorteilhaft auf das Maß der Kompression bzw. Dispersion des Volumen-Bragg-Gitters abgestimmt werden. Deshalb ist keinerlei Justage oder Feinabstimmung über optische Elemente zur Kompression benötigt. Es reicht einzig und alleine den Chirp an der Laserdiode über die elektrischen Parameter auf die Materialkonstante, also die chromatische Dispersion abzustimmen, um einen optimal komprimierten Laserimpuls hinter dem Kompressor zu erhalten. Deswegen kann durch die Einsparung von optischen Elementen, Justage-Aufwand und der kompaktere Aufbau eine Kosteneinsparung erzielt werden.

Bei Bedarf kann der Chirp des Laserimpulses allerdings auch auf andere optische Elemente abgestimmt sein. Für den Fall, dass ein Chirp an einem Experiment beispielsweise erwünscht ist, möglicherweise, um eine chromatische Dispersion eines optischen Elementes zu kompensieren, kann der Chirp des von der Laserdiode emittierten optischen Impulses entsprechend darauf eingestellt werden.

Das bevorzugte Verfahren, umfassend ein Verstärken und ein Komprimieren, erlaubt, auf einfache und elegante Weise, kurze und insbesondere ultrakurze und intensive Laserimpulse bzw. Laserimpulse bzw. elektromagnetische Impulse für diverse Anwendungen zu erzeugen. Beispielsweise kann das Verfahren eine Anwendung in der (Laser-)Spektroskopie/Kurzzeitspektroskopie, Mikroskopie, Medizintechnik und/oder in der (Laser-)Materialbearbeitung finden. Ferner erlaubt das bevorzugte Verfahren das Erzeugen von Laserimpulsen mit hohen Spitzenintensitäten. Bevorzugt können Laserimpulse, durch das System emittiert, von einer Dauer zwischen 100 ps und 10 fs, insbesondere zwischen 5 ps und 500 fs, und von einer Impulsenergie zwischen 10 nJ und 1 μJ, insbesondere über 1 μJ erzeugt werden, wobei insbesondere eine variable Repetitionsrate erzielt werden kann. Beispielsweise kann ein optischer Impuls eine zeitliche Dauer von 100 fs und eine spektrale Breite von mehr als 50 nm bei einer Zentralwellenlänge von 1550 nm haben. Der VCSEL kann dabei bevorzugt in der Lage sein, intrinsisch gechirpte Laserimpulse einer zeitlichen Dauer von einigen Nanosekunden zu erzeugen.

Optional und bevorzugt kann das Verfahren auch den Schritt einer aktiven Temperierung der Laserdiode mittels eines Kühlelements und/oder mittels eines Heizelements, insbesondere eines externen Lasers umfassen.

Eine aktive Temperierung kann erlauben, dass Temperaturen des optisch aktiven Bereichs, insbesondere des Resonators und/oder des optisch aktiven Elements, erreicht werden können, welche dazu führen, optische Impulse mit vorbestimmten Wellenlängen zu emittieren, die ohne aktive Temperierung zumindest in Teilen nicht erhalten werden könnten. Eine zusätzliche aktive Kühlung kann erlauben, dass der optisch aktive Bereich in den Intervallen zwischen der Emission zweier optischer Impulse zurück in eine Ausgangstemperatur versetzt werden kann. Dies (die Reversibilität der Temperaturänderung innerhalb eines Intervalls) kann jedoch beispielsweise in gewissen Temperaturbereichen bzw. zu gewissen Betriebsparametern ausdrücklich auch ohne aktive Kühlung erfolgen. Die Temperierung kann beispielsweise dazu dienen, eine Laserdiode in einen weitestgehend gleichgewichtigen Zustand während des Betriebs zu bringen oder die Temperierung kann dazu dienen, dass die Temperatur gezielt während einer Periode der wiederholten Pulserzeugung die Temperatur der Laserdiode regelt und/oder steuert und/oder ändert. Insbesondere kann ein externer Heizimpuls auch zur aktiven Temperierung, besonders zu einer gepulsten Temperierung verwendet werden. Ein solcher externer Heizimpuls kann beispielsweise durch einen gepulsten Laser erzeugt werden, der elektromagnetische Strahlung emittiert, die in der Lage ist, die erfindungsgemäße Laserdiode von extern zu temperieren. In anderen Worten kann ein zusätzlicher externer Laser eine elektromagnetische Strahlung, insbesondere einen gepulsten Laserimpuls bereitstellen bzw. erzeugen, welcher als Heizimpuls dienen und die erfindungsgemäße Laserdiode temperieren und insbesondere aufheizen bzw. erwärmen kann.

Optional und bevorzugt werden Spannungswerte und/oder Stromwerte des elektrischen Impulses gewählt, die größer sind, als für den Betrieb der Laserdiode empfohlene Spannungswerte und/oder Stromwerte.

In der Regel wird bei der konventionellen Verwendung von Laserdioden, insbesondere von Oberflächenemittern angestrebt, "saubere" und wohldefinierte optische Impulse bzw. elektromagnetische Strahlung bezüglich beispielsweise der Moden, der Frequenzen, des Chirps oder anderer optischer Eigenschaften zu erzeugen. Innerhalb einer bestimmten Betriebstemperatur und Betriebsstromstärke und/oder -spannung, die zumeist von dem Hersteller empfohlen wird bzw. werden, erzeugt eine Laserdiode, insbesondere ein Oberflächenemitter, optische Impulse, die den oben genannten Ansprüchen entsprechen. Laserdioden, insbesondere deren elektrische Eigenschaften, können ferner vom Hersteller derart ausgestaltet sein, dass ein versehentliches Betreiben in einem (Temperatur-)Bereich außerhalb des empfohlenen Bereichs zumindest erschwert wird. Das bewusste Betreiben einer solchen Laserdiode außerhalb eines empfohlenen Bereichs wäre gemessen an dem ursprünglichen Verwendungszweck und der Empfehlungen des Herstellers nicht eingängig bzw. kontraintuitiv und käme für den Verwender in der Regel nicht in Betracht.

Gemäß der vorliegenden Erfindung wurde erkannt, dass ein Betreiben einer Laserdiode, insbesondere eines Oberflächenemitters, in einem Bereich zumindest teilweise außerhalb der vorgegebenen Parameterbereiche einen unerwarteten vorteiligen Effekt mit sich bringen kann. Beispielsweise kann ein Chirp besonders empfindlich auf Temperaturänderungen in diesem Bereich (entsprechend außerhalb des empfohlenen Bereichs) und/oder auf Stromstärkenänderungen in diesem Bereich (entsprechend außerhalb des empfohlenen Bereichs) reagieren. Gemäß der vorliegenden Anmeldung wurde erkannt, dass ein Chirp innerhalb eines optischen Impulses erzeugt wird, wenn die Laserdiode außerhalb der vorgegebenen Parameterbereiche betrieben wird.

Vorzugsweise und optional wird die Laserdiode mittels des elektrischen Impulses betrieben. Insbesondere kann die Laserdiode mittels des elektrischen Impulses betrieben werden, sodass sich während der Impulsdauer des elektrischen Impulses die Temperatur durch einen von dem elektrischen Impuls hervorgerufenen Stromfluss durch die Diode, insbesondere des optisch aktiven Bereichs und bevorzugt des optisch aktiven Mediums zumindest eines Bereichs eines Resonators der Laserdiode verändert, wodurch sich während der Impulsdauer des elektrischen Impulses ein Wellenlängenspektrum bzw. eine instantane Wellenlänge bzw. eine instantanemittierte Wellenlänge bzw. eine augenblicklich emittierte bzw. betrachtete Wellenlänge der von der Laserdiode emittierten elektromagnetischen Strahlung zeitlich ändert.

In anderen Worten wird ein elektrischer Impuls an die Laserdiode angelegt, welcher dazu ausgelegt ist, die Laserdiode zu betreiben, also im Wesentlichen einen Strom durch die Laserdiode, insbesondere durch das optisch aktive Medium derart zu erzeugen, dass ein optischer Impuls generiert bzw. erzeugt und eventuell emittiert wird. Der elektrische Impuls kann dabei ein Spannungsimpuls sein, der einen Stromimpuls bzw. einen pulsartigen Stromfluss durch die Diode, insbesondere durch den optisch aktiven Bereich und bevorzugt durch das optisch aktive Medium erzeugt.

Zusätzlich kann die Laserdiode mittels des elektrischen Impulses außerdem zumindest auch temperiert, insbesondere erwärmt werden. Derart kann sich die Temperatur eines Lasers, insbesondere eines optisch aktiven Bereichs und bevorzugt eines optisch aktiven Mediums zumindest eines Bereichs eines Resonators der Laserdiode während der Zeitdauer bzw. Impulsdauer des elektrischen Impulses durch einen von dem elektrischen Impuls hervorgerufenen optischen Impuls, insbesondere einen Heizimpuls beispielsweise eines externen Lasers, verändern. Dadurch kann sich während der Impulsdauer des elektrischen Impulses ein Wellenlängenspektrum der von der Laserdiode emittierten elektromagnetischen Strahlung zeitlich ändern.

In anderen Worten kann der elektrische Impuls einerseits dazu dienen, die Laserdiode zu betreiben und andererseits, einen externen optischen Impuls zur Temperierung der Laserdiode zu erzeugen.

In anderen Worten kann die Laserdiode vorzugsweise mittels des elektrischen Impulses betrieben werden und insbesondere mittels eines externen Heizimpulses eines Lasers temperiert werden.

Der elektrische Impuls, durch den die Laserdiode insbesondere hinsichtlich einer Temperaturänderung gesteuert werden kann, kann dazu führen, dass ein gepulster Strom durch die Diode fließt, der eine Temperaturänderung, insbesondere eine Erwärmung der Laserdiode hervorruft. Der elektrische Impuls dient in dem Fall also direkt zum Betrieb der Laserdiode zur Erzeugung von gepulster Laserstrahlung und gleichzeitig zur Temperierung insbesondere Erwärmung der Laserdiode. Dazu kann beispielsweise ein Spannungspuls von außen angelegt werden. Dies führt dazu, dass einzig und alleine das Ansteuern und/oder Regeln einer Spannung bzw. eines Spannungspulses oder eines Strompulses (bevorzugt über einen Frequenzgeber und/oder Spannungsregler) der Strom durch eine Laserdiode erzeugt, was wiederum eine Temperaturänderung in der Laserdiode bewirkt. Die Temperaturänderung bewirkt das Emittieren eines optischen Impulses, d.h. elektromagnetischer Strahlung eines der Temperatur entsprechenden Wellenlängenspektrums. Derart können eine Vielzahl von optischen Parametern über den elektrischen Impuls kontrolliert bzw. geregelt und/oder gesteuert werden. Optional oder zusätzlich kann ein elektrischer Impuls auch zum Betreiben eines externen Heizelementes, insbesondere eines optischen Heizelementes zur Erzeugung eines optischen Heizimpulses verwendet werden, wobei das Heizelement die Laserdiode vorzugsweise impulsartig erwärmt und/oder abkühlt, vorzugsweise in Phase mit dem impulsartigen Erzeugen von elektromagnetischer Strahlung. Ein optischer Heizimpuls kann dabei elektromagnetische Strahlung im Wellenlängenbereich von Wärmestrahlung, insbesondere im Infrarotspektrum umfassen.

In einem weiteren möglichen Verfahrensschritt, kann optional ein Wellenlängenbereich vor und/oder nach dem Schritt der Selektion einen überwiegend zeitlich linearen Chirp, also eine lineare zeitliche Verschiebung bzw. Verzögerung von elektromagnetischer Strahlung einer vorgegebenen Wellenlänge oder eines vorgegebenen Wellenlängenbereichs aufweisen und/oder eine überwiegend lineare Abhängigkeit zwischen elektromagnetischer Strahlung einer vorgegebenen Wellenlänge oder eines vorgegebenen Wellenlängenbereichs und Stromstärke durch die Laserdiode aufweisen und/oder eine überwiegend lineare Abhängigkeit zwischen elektromagnetischer Strahlung einer vorgegebenen Wellenlänge oder eines vorgegebenen Wellenlängenbereichs und Temperatur des optisch aktiven Mediums aufweisen.

Die emittierte elektromagnetischer Strahlung einer vorgegebenen Wellenlänge oder eines vorgegebenen Wellenlängenbereichs und insbesondere der Chirp, lassen sich auf besonders einfache Weise, nämlich durch eine lineare Gleichung vorbestimmen. Möchte man beispielsweise elektromagnetische Strahlung eines bestimmten Wellenlängenbereichs erzeugen, so kann einfach berechnet werden, welche linearen Änderungen der Stromstärke und/oder der Temperatur dazu notwendig sind. Für den Fall, dass ein Kompressorelement eine lineare chromatische Dispersion aufweist, also Frequenzen (bzw. Wellenlänge) durchtretender elektromagnetischer Strahlung zeitlich linear gegeneinander "verschiebt", ist es ferner von Vorteil bzw. erforderlich, dass ein Frequenzbereich aus dem Spektrum eines durch eine Laserdiode emittierten optischen Impulses gewählt wird, der in entgegengesetzter Weise einen - die chromatische Dispersion kompensierenden - linearen Chirp aufweist, also eine der chromatischen Dispersion entgegengesetzte lineare zeitliche Verschiebung der Wellenlängen aufweist.

Insbesondere kann sich in einem Verfahrensschritt während der Impulsdauer des elektrischen Impulses ein Wellenlängenspektrum der von dem optisch aktiven Bereich, insbesondere dem optisch aktiven Medium und/oder dem Resonator emittierten elektromagnetischen Strahlung zeitlich ändern.

Die Erfindung betrifft ebenfalls eine Vorrichtung bzw. eine Laserdiode und insbesondere einen Oberflächenemitter, VCSEL, sowie ein System, das die Laserdiode umfasst. Die entsprechenden Vorrichtungen erlauben das Ausüben des zuvor genannten erfindungsgemäßen, sowie bevorzugten Verfahrens. Die genannten technischen Effekte sowie die Vorteile ergeben sich automatisch auch aus den entsprechenden erfindungsgemäßen, sowie bevorzugten Vorrichtungen bzw. Systemen.

Das erfindungsgemäße System zur Erzeugung elektromagnetischer bzw. optischer Impulse d.h. optischer Impulse umfasst: die erfindungsgemäße Laserdiode, insbesondere in einer der bevorzugten Ausführungen und mindestens einen elektronischen Impulsgenerator, welcher dazu ausgelegt ist, den steuerbaren und/oder regelbaren elektrischen Impuls zu generieren und mindestens ein optisches Selektorelement welches dazu ausgelegt ist, einen vorbestimmten spektralen Wellenlängenbereich des optischen Impulses, der während der Impulsdauer des elektrischen Impulses von dem optisch aktiven Medium emittiert wird, zu selektieren.

Bevorzugt und optional umfasst das System ferner ein Selektionselement, welches ein Faser-Bragg-Gitter umfasst, und/oder mindestens ein optisches Verstärkerelement, vorzugsweise umfassend einen Erbiumdotierten Faserverstärker, und/oder mindestens ein Kompressorelement, vorzugsweise umfassend ein Volumen-Bragg-Gitter.

Insbesondere kann der Chirp des von einer Laserdiode emittierten optischen Impulses auf ein Kompressorelement, insbesondere mit einer festen Dispersion und/oder ein dispersives Element und/oder ein Element mit dispersiven Eigenschaften angepasst bzw. abgestimmt bzw. vorkompensiert werden. Damit besteht ein großer Unterschied zu konventionellen Systemen, bei denen ein flexibler Kompressor (Gitter-/Prismenkompressor) auf den vorgegeben Chirp des optischen Impulses angepasst wird.

Die bevorzugte Ausführungsform des Lasersystems erlaubt die Erzeugung ultrakurzer Laserimpulse, insbesondere im Pico- bis Femtosekunden-Bereich. Dieser Schritt erfolgt nach einer Verstärkung der Impulsenergien vorzugsweise auf Nanojoule-Niveau. Die Verstärkung erfolgt vorzugsweise sehr einfach durch einen optischen Faserverstärker. Durch den intrinsischen Chirp, den ein von der Laserdiode emittierter Laserimpuls bereits aufweist, können, wie bei der konventionellen sogenannten "chirped Impulse amplification", insbesondere nicht-lineare optische Effekte bei der Verstärkung vermieden werden, ohne, dass eine Anordnung, die einem sogenannten "Stretcher" entspricht, von dem Laserimpuls durchlaufen werden muss. Diese Kompensation einer variablen Phase erfolgt vorzugsweise nach der Verstärkung und führt schließlich zu kurzen Laserimpulsen mit hohen Spitzenintensitäten.

Insbesondere ist das bevorzugte System in der Lage, ultrakurze Laserimpulse zu erzeugen, deren Dauer lediglich durch das fundamentale Limit der erzeugten optischen Bandbreite begrenzt ist.

Der Begriff "optischer Impuls" oder "Laserimpuls" kann im Hinblick auf Begriffe, wie "gepulster Laser", "Pulslaser" oder "Pulsformung" bzw. "pulse shaping" auch als "optischer Puls" bezeichnet werden.

Einzelne vor- und/oder nachstehend genannte Aspekte der Erfindung und der konventionellen Methoden bzw. Systeme, die sich nicht gegenseitig ausschließen, können beliebig miteinander kombiniert werden oder falls sie voneinander unabhängig sind, als separate Aspekte in Verbindung mit der Erfindung umgesetzt werden. Beispielsweise kann es, falls erforderlich, möglich sein, eine erfindungsgemäße Laserdiode in einem System mit einem konventionellen Kompressor, umfassend beispielsweise optische Gitter und/oder Spiegel, zu kombinieren. Auch kann es beispielsweise möglich sein, ein erfindungsgemäßes System umfassend eine Laserdiode, insbesondere einen Oberflächenemitter, mit zusätzlichen Elementen eines konventionellen Lasersystems, beispielsweise mit einem nachgeschalteten "pulse shaper", zu kombinieren.

Bevorzugte Ausführungsformen der vorliegenden Erfindung werden nachfolgend anhand beispielhafter Figuren beschrieben:

    **Figur 1** stellt schematisch einen beispielhaften konventionellen Laseraufbau zur Erzeugung ultrakurzer Laserimpulse dar;

    **Figur 2** stellt schematisch eine besondere Form einer Laserdiode, nämlich einen Oberflächenemitter, dar;

    **Figur 3a** stellt schematisch eine beispielhafte elektrische Schaltung zur Erzeugung eines an die Diode angelegten elektrischen Impulses dar;

    **Figur 3b** zeigt ein Diagramm umfassend die beispielhaften stromstärkeabhängigen Spannungs- und Leistungsverläufe für zwei unterschiedliche beispielhafte statische Temperaturen, 20 und 80°C;

**Figur 3c** zeigt ein Diagramm umfassend die beispielhaften stromstärkeabhängigen Wellenlängen der emittierten elektromagnetischen Strahlung bei zwei unterschiedlichen statischen Temperaturen, 20 und 80°C;

**Figur 3d** zeigt ein Diagramm, welches die beispielhafte Temperaturabhängigkeit des Wellenlängenspektrums eines von einem Oberflächenemitter emittierten optischen Impulses im statischen Betrieb verdeutlicht;

**Figur 3e** zeigt in einem Diagramm die beispielhaften zentralen Wellenlängen eines Spektrums eines von einem Oberflächenemitter emittierten optischen Impulses und deren Abhängigkeit von der eingestellten Temperatur für zwei unterschiedliche Laserdioden im statischen Betrieb;

**Figur 4** zeigt ein Diagramm betreffend eine beispielhafte zeitliche Form des elektrischen und eines optischen Impulses im direkten Vergleich;

**Figur 5a** zeigt ein Diagramm bezüglich der Auflösung eines beispielhaften Spektrums eines optischen Impulses in mittels Farby-Perot Filter gefilterte Lorentz-Anteile;

**Figur 5b** zeigt ein Diagramm bezüglich der beispielhaften zeitlichen Verteilung spektraler Anteile eines optischen Impulses;

**Figur 5c** zeigt ein Diagramm, in dem eine beispielhafte Verzögerung von 40 spektralen Anteilen bzw. zentralen Wellenlängen gegen einen ersten Anteil bzw. eine erste Wellenlänge aufgetragen sind;

**Figur 6** umfasst fünf Diagramme zur schematischen Darstellung, wie die Form eines elektrischen Impulses den Chirp bestimmt;

**Figur 7a** zeigt ein Diagramm, welches beispielhafte zeitliche Verläufe der jeweiligen Spannung elektrischer Impulse darstellt;

**Figur 7b** zeigt ein Diagramm, welches die beispielhaften Spektren der optischen Impulse entsprechend der in Figur 7a dargestellten elektrischen Impulse darstellt;

**Figur 7c** zeigt ein Diagramm, welches eine beispielhafte Anhängigkeit zwischen einer optischen Impulsdauer nach dem Passieren eines Selektors und eines Kompressors und einer angelegten Spannung verbildlicht;

**Figur 8a** stellt schematisch ein beispielhaftes System zur Erzeugung ultrakurzer Laserimpulse umfassend die erfindungsgemäße Laserdiode dar;

**Figur 8b** stellt schematisch eine besondere Ausführungsform eines Lasersystems zur Erzeugung ultrakurzer Laserimpulse basierend auf Faser-Elementen und umfassend einen Oberflächenemitter dar;

**Figur 9a** zeigt ein Diagramm, welches eine beispielhafte Simulation einer Gruppenverzögerung, sowie einer Reflexion eines gechirpten Faser-Bragg-Gitters darstellt;

**Figur 9b** zeigt ein Diagramm, welches die Messdaten umfasst, die der beispielhaften Simulation aus Figur 9a entsprechen;

**Figur 10** stellt schematisch die Funktionsweise eines gechirpten Faser-Bragg-Gitters dar;

**Figur 11a** zeigt ein Diagramm, welches ein beispielhaftes Spektrum eines ungefilterten von einem VCSEL emittierten und verstärkten optischen Impulses vor der Selektion und Kompression mit dem entsprechenden Spektrum des optischen Impulses nach einer beispielhaften Selektion und Kompression vergleicht;

**Figur 11b** zeigt ein Diagramm, welches einen beispielhaften zeitlichen Verlauf eines optischen Impulses vor einer Selektion, eines optischen Impulses nach einer ersten beispielhaften Selektion und eines optischen Impulses nach einer zweiten beispielhaften Selektion vergleicht.

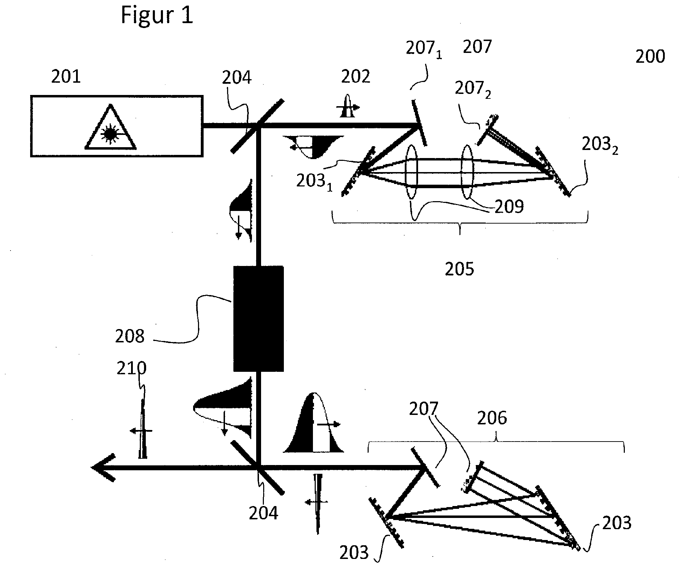

Der Begriff "Chirp" beschreibt, wie zuvor erwähnt, das Maß, in dem eine Wellenlänge oder Frequenz gegenüber einer anderen Wellenlänge oder Frequenz innerhalb eines Laserimpulses zeitlich verschoben ist. Eine solche zeitliche Verschiebung verschiedener Wellenlängen gegeneinander kann herkömmlicherweise beispielsweise durch eine Anordnung, wie in **Figur 1** gezeigt, aus optischen Gittern und Spiegeln erzeugt oder kompensiert werden (siehe beispielsweise in **Figur 1** die Anordnung des sogenannten Streckers oder Impulsbzw. Pulsstreckers (Engl.: stretcher) 205 und des sogenannten Kompressors oder Impuls- bzw. Pulskompressors (Engl.: compressor) 206).

Das erfindungsgemäße Verfahren erzeugt jedoch mittels einer Laserdiode insbesondere eines Oberflächenemitters einen - bereits während der Entstehung/Erzeugung - "gechirpten" optischen Impuls, der also schon intrinsisch einen Chirp aufweist, sodass vorteilhafterweise auf Elemente bzw. Anordnungen, die einem Pulsstreckers 205 gemäß **Figur 1** entsprechen würden oder könnten, verzichtet werden kann. Dabei wird Licht bzw. elektromagnetische Strahlung nach Wellenlängen bzw. Frequenzen räumlich aufgefächert. Durch Weglängendifferenzen des Lichts verschiedener Wellenlängen, welche entlang unterschiedlicher Weglängen propagieren, wird eine zeitliche Verschiebung bzw. Verzögerung zwischen elektromagnetischer Strahlung verschiedener Wellenlängen hervorgerufen. Ein "positiver Chirp" liegt dabei vor, wenn die Frequenz zeitlich zunimmt. Beispielsweise wäre dies der Fall, wenn ein rotes Licht einem blauen Licht vorauseilt. Im umgekehrten Fall würde es sich um einen negativen Chirp handeln. Bevorzugt kann ein negativer Chirp durch die erfindungsgemäße Methode erzielt werden, wobei die Werte in ns oder ps/nm ein positives Vorzeichen aufweisen. Alternativ kann auch ein positiver Chirp erzeugt werden.

Der Begriff "Licht", der in der Beschreibung genannt wird, begrenzt sich im Zusammenhang mit der Beschreibung ausdrücklich nicht auf das Frequenzspektrum des sichtbaren Lichts, sondern umfasst allgemein den Begriff der elektromagnetischen Strahlung, die beispielsweise durch einen Laser emittiert wird bzw. werden kann. Der Wellenlängenbereich eines solchen Lichts kann beispielsweise Wellenlängen im Bereich des Nahinfrarot (etwa 780 nm bis 3 $\mu$m) und/oder des mittleren Infrarot (etwa 3 $\mu$m bis 50 $\mu$m) und/oder des Ferninfrarot (etwa 50 $\mu$m bis 1 mm) und/oder des (für einen Menschen) sichtbaren Lichts (380 nm bis 780 nm) und/oder des UV Lichts (380 nm bis 10 nm) umfassen. Der Wellenlängenbereich eines solchen Lichts muss sich aber nicht auf die oben genannten Bereiche begrenzen, kann also auch Wellenlängen außerhalb der genannten Bereiche umfassen.

Der Begriff des elektromagnetischen Impulses betrifft kurze Laserimpulse, bzw. gepulstes Laserlicht. Anders als ein Dauerstrichlaser (Engl.: continuous-wave laser, kurz: cw-laser), der ein Licht konstanter Intensität eines schmal-bandigen, d.h. monochromen, einfarbigen Laserlichts bzw. elektromagnetischer Strahlung emittiert, emittiert ein Pulslaser bzw. gepulster Laser pulsierende elektromagnetische Strahlung bzw. kurze Laserimpulse eines vorzugsweise breiten, also zumindest nicht monochromatischen Frequenzspektrums ab.

Kurze Laserimpulse, umfassen allgemein überwiegend optische Impulse mit einer Impulsdauer zwischen etwa einer ms (1 Millisekunde = 0.001 s) und etwa mehreren ns (1 Nanosekunde = 0,000.000.001 s). Ultrakurze Laserimpulse umfassen Laserimpulse, die kürzer als 1 ps sind, insbesondere mit einer Impulsdauer zwischen etwa einer ps (1 Picosenkunde = 0,000.000.000.001 s) und etwa einer fs (1 Femtosekunde = 0,000.000.000.000.001 s). Es können mit speziellen Pulslasern allerdings auch extreme optische Impulse im Attosekundenbereich (1 Attosekunde = 0,000.000.000.000.000.001 s) erzielt werden. Auch werden Pulslaser im ultrakurzen Zeitbereich bei Zeitskalen zwischen wenigen Femtosekunden bis etwa zehn Picosekunden angesiedelt.

Das Verfahren zur Erzeugung ultrakurzer Laserimpulse gemäß einer bevorzugten Ausführungsform, insbesondere umfassend die Schritte des Verstärkens und der Kompression, betrifft insbesondere den Bereich von Impulsdauern zwischen Nanosekunden und Femtosekunden. Vorzugsweise liegt die Impulsdauer eines optischen Impulses, der von einem Oberflächenemitter emittiert wird, im Nanosekundenbereich, beispielsweise bei 1 bis 20 ns, insbesondere bei 5 bis 15 ns.

Vorzugsweise liegt die Impulsdauer eines optischen Impulses, der nach der Emission durch eine Laserdiode einen optischen Verstärker und einen Kompressor durchlaufen hat, im Picosekunden- oder Femtosenkundenbereich, beispielsweise bei 3,5 ps oder zwischen 100 fs und 5 ps, insbesondere in einem Bereich von weniger als 1 ps. Die Femtosekunde ist ferner die Zeitskala, auf der sichtbares Licht schwingt. Ein optischer Impuls von beispielsweise 5 fs Dauer erstreckt sich also nur über wenige optische Perioden.

Anders als herkömmliche Laser zeichnen sich gepulste Laser, wie bereits erwähnt, nicht durch schmalbandige insbesondere monochromatische elektromagnetische Strahlung aus, sondern umfassen ein "breites" Spektrum an Wellenlängen, welches zumindest nicht monochromatisch ist. Die Breite eines Spektrums gibt vor, wie kurz ein Laserimpuls mit diesem Spektrum sein kann. Für das Verhältnis zwischen Breite eines Spektrums und Impulsdauer gilt: Je breiter das Frequenzspektrum, desto kürzere Laserimpulse können erzielt werden. Über eine Fourier-Transformation sind der zeitliche Verlauf und das Spektrum eines optischen Impulses miteinander verknüpft. Entscheidende Voraussetzung ist dabei allerdings, dass die Schwingungen der unterschiedlichen Frequenzen eine feste Phasenbeziehung zueinander besitzen. Nur dann führt ihre Überlagerung zu einem kurzen Lichtimpuls. Verändert man diese Phasenlage bzw. die relativen Amplituden der einzelnen spektralen Komponenten, so kann man fast beliebige Impulsformen auf einer Zeitskala von einigen 10 fs herstellen. Mit Hilfe solcher optischen Impulse lässt sich dann eine ganze Reihe wichtiger ultraschneller Prozesse untersuchen, die von den kohärenten Anregungen in Halbleitern über das ultraschnelle Verhalten von Supraleitern bis zu den chemischen und biologischen Elementarreaktionen reichen.

**Figur 1** stellt einen konventionellen Laseraufbau 200 zur Erzeugung ultrakurzer Laserimpulse 210 dar. Das beispielhaft schematisch dargestellte System 200 umfasst einen Anregungslaser 201 (Engl.: seed laser), welcher einen optischen Impuls 202 emittiert. Der Seedlaser 201 kann beispielsweise ein modengekoppelter Laseroszillator sein.

Konventionelle Lasersysteme 200 zur Erzeugung ultrakurzer Laserimpulse, wie das in **Figur 1** gezeigte, verwenden in den meisten Fällen die sogenannte Chirp-Impulsverstärkung (Engl.: chirped pulse amplification) zur Vermeidung, dass optische Impulse 202 mit zu hoher Spitzenleistung einen Verstärker 208 durchlaufen und dort Schäden entstehen.

Der vom Anregungslaser 201 (seed laser) emittierte optische Impuls 202 (auch "seed" genannt) wird dazu zunächst über einen ersten Spiegel $207_1$ in einen Impulsstrecker 205 gesandt. Der Impulsstrecker 205 umfasst in dem gezeigten Beispiel optische Gitter 203 und Spiegel 207, sowie optische Linsen 209. An dem ersten optischen Gitter $203_1$ wird der optische Impuls 202 zunächst räumlich "zerlegt" bzw. räumlich aufgefächert. Nach dem Durchlaufen eines Linsensystems passiert der Laserimpuls 202 ein weiteres optisches Gitter $203_2$ hinter dem der Laserimpuls 202 dann an einem Spiegel $207_2$ reflektiert wird und den Impulsstrecker 205 dann rückwärtig durchläuft. Innerhalb des Impulsstreckers 205 durchläuft das Licht einer Wellenlänge gegenüber dem einer anderen - ob der örtlichen Auffächerung und der Verkippung des zweiten Spiegels $207_2$ - eine längere Wegstrecke. Nachdem der optische Impuls 202 den Impulsstrecker 205 wieder verlässt und davor der optische Impuls 202 das erste optische Gitter $203_1$ ein zweites Mal, diesmal rückwärtig passiert, sind die Wellenlängen örtlich wieder "vereint". Das optische Gitter $203_1$, welches den Laserimpuls 202 zuvor aufgefächert hat, projiziert diesen beim zweiten Durchlaufen im Wesentlichen auf die Fläche, die der Laserimpuls 202 vor dem Eintritt in den Impulsstrecker 205 hatte. Der Laserimpuls 203 liegt an diesem Punkt, nach dem Passieren des Impulsstreckers, zeitlich gestreckt bzw. gechirpt vor. Die Energie, die der optische Impuls 202 nach seiner Emission aus den Anregungslaser 201 aufweist, verteilt sich derart auf einen zeitlich längeren Laserimpuls, was bewirkt, dass die Spitzenleistung und entsprechend die Intensität und die Leistungsdichte des Laserimpulses 202 durch das zeitliche Strecken reduziert werden kann. Dieser Schritt wird insbesondere vor dem Passieren eines Verstärkerelementes bzw. eine Verstärkermediums 208 benötigt, um beispielsweise zu vermeiden, dass möglicherweise unerwünschte nicht-lineare Effekte in dem Verstärkermedium auftreten.

Der aus dem Impulsstrecker 205 austretende optische Impuls wird durch Reflexion an einem gegenüber dem eintretenden Laserstrahl "nach unten" versetzten Spiegel 204 in einen Verstärker 208 geleitet. Der vertikale Versatz des Spiegels 204 hat den Vorteil, dass der einfallende Strahl nicht von dem Spiegel 204 blockiert wird und der ausfallende Strahl hingegen von einer Reflexion daran betroffen ist. Dazu kann der aus dem Impulsstrecker 205 austretende Laserstrahl gegenüber dem eintretenden Laserstrahl durch Verkippung des zweiten Spiegels $207_2$ vertikal versetzt sein, derart, dass der aus dem Impulsstrecker 205 austretende optische Impuls von dem Spiegel 204 reflektiert wird.

Ein typischer Verstärker 208 kann beispielsweise ein sogenannter regenerativer Verstärker sein und ein aktives Lasermedium (nicht in der Figur gezeigt), beispielsweise ein Titan:Saphir-Lasermedium (Ti:Sa) umfassen. Ein solcher Verstärker 208 kann auch als Verstärkerresonator bezeichnet werden. Der gechirpte Laserimpuls 202, der in den Verstärker 208 eintritt, passiert das Lasermedium innerhalb des Verstärkerresonators mehrmals.

Nach dem Durchlaufen des Verstärkers 208 passiert der verstärkte und zeitlich immer noch gestreckte bzw. gechirpte Laserimpuls 202 einen Impulskompressor 206, der ähnlich wie der Impulsstrecker 205 optische Gitter 203 und Spiegel 207 umfasst. Die zeitliche Verzögerung, die eine Wellenlänge gegenüber einer anderen Wellenlänge in dem Impulsstrecker 205 erfahren hat wird im Impulskompressor 206 mit demselben Prinzip weitestgehend umgekehrt bzw. kompensiert bzw. rückgängig gemacht, indem nun das "vorauseilende" Licht einer ganz bestimmten Wellenlänge (d.h. die elektromagnetische Strahlung mit dieser Wellenlänge) eine entsprechende zeitliche Verzögerung durch einen etwas längeren Strahlengang erfährt relativ zu einem "verzögerten" Licht einer anderen Wellenlänge. Nach passieren bzw. Reflexion an einem Spiegel 204, der gegenüber dem auftretenden Laserstrahl etwas "nach unten" oder "oben" versetzt ist, können typischerweise Laserimpulse 210 mit Millijoule Energien, im zeitlichen Pico- bis Femtosekundenbereich zu vorbestimmten festen Repetitionsraten das System 200 verlassen.

Zur Erzeugung von kurzen optischen Impulsen in derartigen Lasersystemen 200 kommt insbesondere die sogenannte Modenkopplung, sowie die Güteschaltung auch als "Q-switch" bezeichnet zum Einsatz, die dem Fachmann hinlänglich bekannt sind und daher hier nicht näher beschrieben werden.

Ein derartiges konventionelles Lasersystem 200 umfasst eine Vielzahl an optischen Elementen, die in regelmäßigen Zeitabständen alle optimal aufeinander abgestimmt werden, um Laserimpulse zu erzeugen, die die die bevorzugten Eigenschaften bezüglich beispielsweise Energie, Impulsdauer, und entsprechend Leistung aufweisen.

Im Folgenden werden Vorrichtungen, die die Erfindung oder besondere Aspekte betreffen, insbesondere bevorzugte Ausführungsformen der Erfindung darstellen, sowie entsprechende beispielhafte Messergebnisse vorgestellt. Die Ausführungsformen und Aspekte der Ausführungsformen sind dabei ausdrücklich kombinierbar insofern sie sich nicht gegenseitig ausschließen. Ferner können Aspekte besonderer Ausführungsformen auch separat verwirklicht werden, sofern sie nicht von anderen Aspekten abhängen.

Wie bereits zuvor erwähnt, kann es vorteilhaft für bestimmte Laseranordnungen und/oder Experimente sein, wenn ein kurzer insbesondere ein ultrakurzer Laserimpuls einen Chirp aufweist. Beispielsweise kann es von Vorteil sein, dass ein Laserimpuls vor dem Durchlaufen optischer Elemente durch einen Chirp zeitlich gestreckt vorliegt, da eine zu hohe Spitzenleistung bzw. Intensität des Laserimpulses zu unerwünschten optischen Effekten führen könnte. Ferner kann ein zuvor festgelegter Chirp derart auf ein Experiment bzw. eine optische Anordnung eingestellt werden, dass im Vorfeld optische Effekte kompensiert werden können, die bei dem Durchlaufen von optischen Elementen auftreten können. In dem Fall läge eine sogenannte (erwünschte) Vorkompensation vor. Beispielsweise kann ein optischer Impuls beim Durchlaufen eines Mediums einen unerwünschten Chirp erfahren, der wiederum dadurch kompensiert werden kann, dass die emittierende Laserdiode darauf eingestellt wird, dem optischen Impuls zuvor einen entgegengesetzten Chirp zu verleihen, der den unerwünschten Effekt kompensiert.

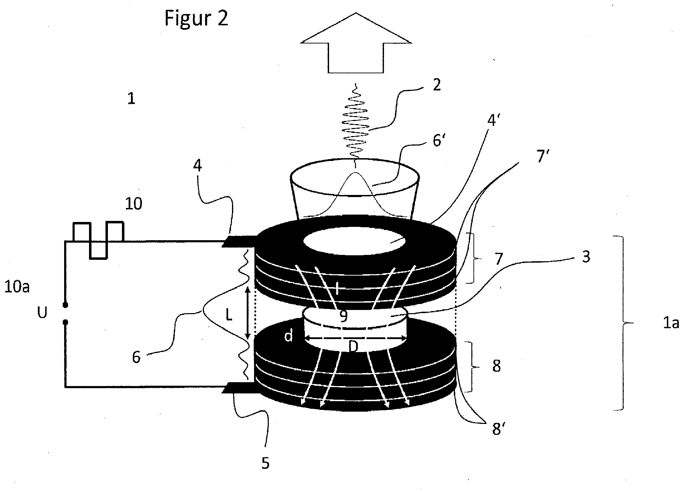

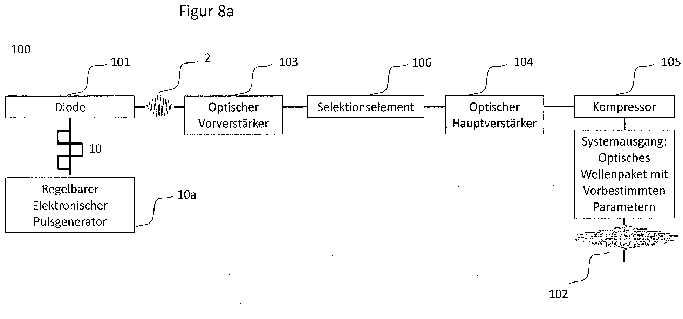

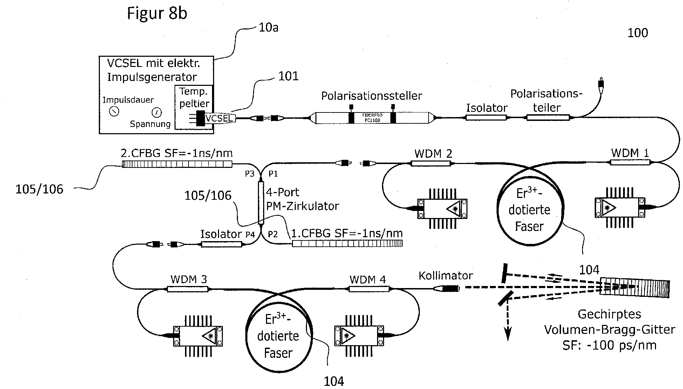

Im Hinblick auf die Erzeugung und Kontrolle solcher kurzer gechirpter optischer Impulse wird zunächst eine Ausführungsform einer Laserdiode 1, die insbesondere einen Oberflächenemitter 1, d.h. VCSEL 1, umfasst beispielsweise gemäß **Figur 2** betrachtet. Eine Ausführungsform eines Systems 100, umfassend eine solche Laserdiode 101, zur Erzeugung komprimierter optischer Impulse mit hohen Energien wird beispielsweise gemäß **Figur 8a** und/oder **Figur 8b** im Anschluss betrachtet.

Die folgenden Abschnitte beziehen sich zunächst insbesondere auch auf die Fragestellung, inwieweit es möglich ist, eine besondere Form der Laserdiode, nämlich einen VCSEL 1 beispielsweise gemäß **Figur 2** mittels elektrischer Impulse 10 derart zu betreiben, dass sich der Resonator 1 a der Laserdiode während eines elektrischen Impulses 10 durch Erwärmung verändert, insbesondere ausdehnt und eine Verschiebung der Wellenlänge des emittierten Lichts verursacht. Eine derartige Verschiebung der instantanen Wellenlängen während eines elektrischen Impulses 10 wird genutzt, um kurze optische Impulse 2, insbesondere gechirpte optische Impulse 2 zu erzeugen.

**Figur 2** zeigt schematisch den strukturellen Aufbau eines VCSEL 1, auch Oberflächenemitter 1 genannt. Der VCSEL findet in einer besonders bevorzugten Ausführungsform als Laserdiode 1 Anwendung. Ein Oberflächenemitter 1 umfasst einen Resonator 1 a. Der Resonator 1 a umfasst einen oberen Reflektor oder Spiegel 7 und einen unteren Reflektor oder Spiegel 8, insbesondere eine obere Reflektoranordnung 7 und eine untere Reflektoranordnung 8, jeweils umfassend eine Bragg-Schichtung mit einer Mehrzahl von Bragg-Schichten 7', 8'. Darüber hinaus umfasst der Resonator 1 a ein optisch aktives Medium 3, welches bevorzugt im Wesentlichen zwischen den Reflektoren 7, 8 angeordnet ist. Die Reflektoren 7, 8 sind dabei bevorzugt überwiegend parallel zueinander und zu der Ebene des optisch aktiven Mediums 3, welches bevorzugt ein Halbleiter sein kann, angeordnet.

Zwischen den Reflektoren 7, 8 befindet sich eine aktive Zone (üblicherweise mit zweidimensionalen Quantentöpfen, auch Quantenfilm genannt) mit dem optisch aktiven Element 3 umfassend den Halbleiter. Das optisch aktive Element 3 weist eine Schichtdicke d und einen Durchmesser D auf und dient zur Erzeugung von gepulstem Laserlicht. Der Raum innerhalb des Resonators 1 a kann als Kavität bezeichnet werden. Die Kavität weist eine bestimmte Länge L auf, innerhalb derer sich zumindest teilweise das optisch aktive Element 3 befindet. Die Länge L des Resonators kann auf wenige Wellenlängen reduziert sein. Das Volumen des optisch aktiven Mediums 3 eines VCSEL 1 kann beispielsweise um das 300-fache kleiner sein, als das eines üblichen Kantenemitters. Sehr geringe Schwellenströme und hohe Modulationsfrequenzen sind Vorteile der Struktur. Es wird jedoch typischerweise eine hohe Reflektivität der Reflektoren 7, 8 benötigt, damit eine stimulierte Emission von optischen Pulsen 2 trotz sehr kleinem Volumen des optisch aktiven Mediums 3 möglich ist.

Die dargestellten Reflektoren 7, 8 umfassen in dem vorliegenden Beispiel jeweils eine Schichtung von Bragg-Schichten 7', 8' mit abwechselnd niedrigem und hohem Brechungsindex, die vorzugsweise jeweils eine optische Weglänge von einem Viertel der Laserwellenlänge im Material haben. Dadurch kann ein bevorzugter Reflexionsgrad von über 99% erzielt werden. Insbesondere der Einsatz von Hybridspiegeln, also beispielsweise einer Kombination aus Bragg-Schichtungen und metallischen Spiegeln, kann sich vorteilhaft auf die thermischen Eigenschaften bzw. die thermische Kontrolle bzw. die Temperierung der Laserdiode auswirken. Ferner können die geometrischen Dimensionen eines Oberflächenemitters 1 im Mikrometerbereich liegen, weshalb besonders niedrige Ausgangsleistungen verglichen mit denen eines Kantenemitters erzielt werden können.

Die Form des Frequenzspektrums des optischen Impulses 2 hängt vom Material des aktiven Mediums 3 und somit von der Bandstruktur des verwendeten Halbleiters ab. Die Wahl des Grundmaterials und der Dotierung für einen Oberflächenemitter 1 und Strahlung-emittierende Laserdioden im Allgemeinen entscheidet also überwiegend darüber, welche Frequenzen bzw. Frequenzbereiche von dem Emitter 1 emittiert werden können. Oberflächenemitter 1, die elektromagnetische Strahlung mit Wellenlängen zwischen 650 nm und 1300 nm emittieren, basieren zumeist auf GaAs-Wafern bzw. GaAs-Halbleitern, während bei Oberflächenemittern 1, die elektromagnetische Strahlung mit Wellenlängen zwischen 1300 nm und 2000 nm aussenden, zumindest das aktive Element 3 zumeist mindestens teilweise auf InP oder GaInAsN basiert. Laserdioden können jedoch im Allgemeinen auch andere Materialien umfassen.

Aus **Figur 2** ist ferner zu entnehmen, dass an den beiden Reflektoren 7, 8 des Oberflächenemitters 1 jeweils eine Elektrode 4, 5 gelagert ist. An den Elektroden 4, 5 kann eine Spannung U angelegt werden, welche veranlasst, dass ein Strom I entlang einer beispielhaft dargestellten Flussrichtung 9 des elektrischen Stroms I, fließen kann. Wesentlich dabei ist, dass der Strom I zwischen den Elektroden 4, 5 durch das optisch aktive Element 3, also das Halbleitermaterial fließt. Dabei überwindet der Strom I eine Mehrzahl von Halbleiter-Sperr-Schichten. Durch Rekombinationsprozesse, die stattfinden während ein Strom I durch das optisch aktive Medium 3 fließt, wird elektromagnetische Strahlung 2 in eine Propagationsrichtung 2' durch eine Öffnung 4' emittiert. Es bildet sich innerhalb des Resonators 1a, inklusive der Schichten der Bragg- Schichten 7, 8 ein transversales Modenfeld 6 aus. Senkrecht zur planaren Oberfläche des optisch aktiven Mediums 3 wird elektromagnetische Strahlung 2, vorzugsweise monomodige elektromagnetische Strahlung 2 emittiert und es bildet sich ein longitudinales Modenfeld 6' aus. Die Flussrichtung des Stroms I, der im Wesentlichen der schematisch dargestellten Richtung 9 folgt, ist somit überwiegend oder zumindest in Teilen parallel zu der Propagationsrichtung der elektromagnetischen Strahlung bzw. der emittierten optischen Impulse 2, die den Oberflächenemitter 1 durch eine Öffnung verlassen können.

Der oben beschriebene Prozess kann als elektrisches "Pumpen" einer Laserdiode 1 verstanden werden, denn es werden Ladungsträger in das optisch aktive Medium 3 "hineingepumpt", was das Emittieren von elektromagnetische Strahlung 2 auslöst. Im Allgemeinen kann ein Oberflächenemitter 1 optisch oder aber elektrisch "gepumpt" werden. Im vorliegenden Beispiel und gemäß der Erfindung wird die Laserdiode 1 bzw. der Oberflächenemitter 1 elektrisch "gepumpt". Durch die Wahl eines elektrischen Impulses 10 (bzw. dessen Form, Länge, Amplitude und/oder Frequenz), können beispielsweise die zeitliche Form und Dauer, die Wellenlänge bzw. der Frequenzbereich, die Intensität und die Wiederholungsrate eines optischen Impulses 2 bestimmt und gesteuert werden.

Bei dem Begriff "elektrischer Impuls" kann es sich einerseits um einen Stromimpuls oder andererseits um einen Spannungsimpuls handeln. Beispielsweise kann über einen Pulsgenerator 10a eine Spannung U geregelt werden, die einen Strom I durch ein Medium, hier durch das optisch aktive Medium 3 verursacht, hauptsächlich gemäß dem Ohm'schen Gesetz. Ein Pulsgenerator 10a kann alternativ auch einen Strom I regeln, je nachdem, über welche Größe eine Laserdiode 1 angesteuert werden soll. Um optische Impulse 2 zu erzeugen, ist es typischerweise notwendig, kurze aufeinanderfolgende bzw. mit einer oder mehreren Frequenzen wiederkehrende Spannungen U an den Elektroden 4, 5 anzulegen bzw. Ströme I zwischen den Elektroden 4, 5 durch das optisch aktive Medium 3 fließen zu lassen. Dabei können die jeweiligen Amplituden variieren. Es kann auch ein beliebiger Ablauf bzw. ein beliebiges vorzugsweise vorbestimmtes Muster von elektrischen Impulsen 10 unterschiedlicher Mittelwerte, Amplituden, Frequenzen oder Impulsdauern durchlaufen werden. Ferner können sich die Parameter beispielsweise auch dynamisch gesteuert durch den Frequenzgeber bzw. Pulsgenerator 10a an einen sich ändernden Widerstand anpassen.

Es wird insbesondere dann ein optischer Impuls 2 mit Chirp emittiert, wenn elektrische Impulse 10 angelegt werden, die einen gepulsten Stromfluss durch das optisch aktive Medium 3 von einer Elektrode zur anderen 4, 5 hervorrufen, welcher eine Temperaturänderung, insbesondere eine Erwärmung des Resonators 1 a bewirkt.

Die Ansteuerung eines Oberflächenemitters 1 bzw. einer Halbleiter-Laserdiode 1 erfolgt dabei bevorzugt mittels eines elektrischen Impulses 10 von einigen Nanosekunden Dauer. Daraus resultiert die Emission von optischen Impulsen 2 mit einer Dauer von einigen Nanosekunden. Die kontinuierliche Energiezufuhr resultiert in einer Änderung des Betriebszustandes der Laserdiode 1 bzw. des Halbleiterlasers 1, während des elektrischen Impulses. Beispielsweise kann dies zu einer Erwärmung der Laserdiode 1 und/oder einer variierenden bzw. sich ändernden Ladungsträgerverteilung innerhalb des optisch aktiven Mediums 3 führen. Durch diesen Prozess verschiebt sich die instantane Wellenlänge des durch den kompakten Halbleiterlaser emittierten optischen Impulses 2 vorzugsweise kontinuierlich. Die erzeugten optischen Impulse 2 weisen entsprechend einen vorzugsweise linearen Chirp bzw. eine quadratische Phase auf, die sich vorzugsweise im Wesentlichen über mehrere Nanometer an spektraler Bandbreite erstreckt.

Ein Gehäuse einer (VCSEL-)Diode 1 kann an einem optionalen Kühl- bzw. Heizkörper wärmeleitend angebracht bzw. gelagert sein. Die Temperatur kann beispielsweise von einem Thermistor gemessen und mit einem Peltier-Element nachgeregelt werden. Auf diese Weise kann vorzugsweise ein Temperaturbereich von 10 °C bis 50 °C erreicht werden. Es können jedoch auch höhere oder niedrigere Temperaturen erzielt werden, beispielsweise 80° C. Durch den optionalen Kühl- bzw. Heizkörper kann beispielsweise eine Laserdiode 1 auf eine im Wesentlichen statische Temperatur eingestellt werden während sie betrieben wird.

Ein elektrischer Impuls könnte auch einen Strom und/oder Spannungspuls umfassen, welcher das Kühl- bzw. Heizelement und/oder insbesondere einen externen optischen Heiz-Impuls bzw. eine gepulste elektromagnetische Heiz-Strahlung dazu veranlasst, impulsartig bzw. pulsartig eine Temperatur der Diode 1 bzw. des Resonators 1 a zu verändern. Ein solcher optischer Heiz-Impuls könnte beispielsweise im Wellenlängenbereich des Infrarotlichts liegen und eine Dauer im Nanosekundenbereich aufweisen. Insbesondere kann dies in der Repetitionsrate der emittierten Laserimpulse 2 geschehen. Auch kann der Heiz-Puls durch einen separaten Laser erzeugt werden, der sich einem gleichen Chip, wie die erfindungsgemäße Laserdiode befindet.

Die Verschiebung einer emittierten Wellenlänge wird regelmäßig damit begründet, dass sich der Brechungsindex der Bragg- Schichten 7, 8 durch eine hohe und schnelle Injektion der Ladungsträger ändert. Die Brechungsindizes der verschiedenen Materialschichten der Bragg- Schichten und des aktiven Mediums ändert sich also durch eine schnelle Ladungsträgerinjektion auf kurzen Zeitskalen (wenige ps) aber auch durch Erwärmung auf langen Zeitskalen (wenige ns). Eine weitere Begründung für die temperaturabhängige Verschiebung des emittierten Spektrums liegt demnach in der thermischen Ausdehnung des Materials des Resonators 1 a, was beispielsweise dazu führen kann, dass der Resonator 1a umfassend die Reflektoren 7,8 seine optische Weglänge verändert.

In anderen Worten ausgedrückt kann sich innerhalb einer Dauer eines elektrischen Impulses die Temperatur von mindestens einem Spiegel bzw. Reflektor, bevorzugt von zwei Spiegeln bzw. Reflektoren erhöhen. Insbesondere können sich Reflektoranordnungen umfassend mehrere Bragg-Schichten erwärmen. Alternativ oder zusätzlich kann sich die Temperatur des optisch aktiven Mediums 3 zwischen zwei Reflektoren 7, 8 des Resonators 1 a erhöhen. Alternativ oder zusätzlich kann sich auch ein anderes Element des Resonators 1 a oder ein an den Resonator angrenzendes Element, beispielsweise eine Materialschicht und/oder eine Elektrode erwärmen. Dabei kann sich die Temperatur zumindest eines Elements des Resonators 1a derart erhöhen, dass sich eine optische Weglänge innerhalb des Resonators, insbesondere die Resonatorlänge L verändert, insbesondere verlängert. Eine solche Temperatur- und Weglängenänderung kann zur Folge haben, dass sich die Resonatorbedingung in einem Zeitintervall ändert. Dadurch können innerhalb des Zeitintervalls, in dem sich die Temperatur ändert, unterschiedliche Wellenlängen die Resonatorbedingung erfüllen, sodass im Endergebnis ein optischer Impuls bzw. Puls 2 mit sich zeitlich ändernden Frequenz- bzw. Wellenlängenanteilen emittiert wird. <n> ist der mittlere räumliche Brechungsindex der VCSEL Diode. Die emittierte Wellenlänge λ der VCSEL Diode kann über die Resonatorbedingung errechnet werden:

$$\lambda = (2 * <n> * L)/m$$

dabei ist "L" die Länge des Resonators und "m" eine natürliche Zahl. Abhängig von der Konstruktion der VCSEL Diode ändert sich die emittierte Wellenlänge λ stärker aufgrund des Brechungsindexes, da die Änderung der Resonatorlänge L vergleichsweise gering ausfällt.

Das Verhalten eines Schwellenstroms, also eines Stromwertes ab dem ein Oberflächenemitter zu emittieren beginnt, ergibt sich bei der Erwärmung aus der relativen Verschiebung des breiten Verstärkerspektrums des aktiven Mediums 3 zu einer sehr schmal-bandigen Resonatorbedingung. Das Verstärkerspektrum verschiebt sich meist schneller zu hohen Wellenlängen als die Resonatorbedingung. Damit eine große Betriebstemperaturspanne abgedeckt wird, sitzt die Resonatormode bei Raumtemperatur meist auf der langwelligen Flanke des Verstärkerspektrums. Trifft sie auf das Maximum, wird der kleinste Schwellstrom erreicht.

Das Verstärkerspektrum ist der spektrale Verlauf der Kleinsignalverstärkung des aktiven Mediums des VCSEL. Ist diese Größe positiv, so tritt bei der entsprechenden Frequenz bzw. Wellenlänge eine Verstärkung auf. Eine negative Verstärkung bedeutet, dass eine Absorption bzw. ein Verlust stattfindet. In diesen Frequenzbereichen ist keine Laseraktivität möglich.

Das Verstärkerspektrum eines aktiven Mediums entspricht dem Emissionsspektrum eines (Halbleiter-)Materials und ist das Gegenstück zu dem Absorptionsspektrum. Das aktive Medium eines Lasers besitzt bevorzugt ein breites kontinuierliches Emissionsspektrum. Das aktive Medium kann elektrisch oder mit Frequenzen, die im Absorptionsspektrum liegen, gepumpt werden. Das aktive Medium emittiert ohne Seed die Frequenzen des Emissionsspektrums (ASE) und/oder emittiert durch stimulierte Emission einen verstärkten optischen (Seed-)Impuls, dessen Frequenz im Emissionsspektrum liegt.

Insbesondere in Oberflächenemittern 1 verläuft der Stromfluss I direkt durch die Bragg-Schichtung der Resonatorspiegel 7, 8. Eine induzierte Wärme kann somit starken Einfluss auf die zentrale Wellenlänge der emittierten elektromagnetischen Strahlung bzw. des emittierten Laserimpulses 2 haben. Das sehr kleine Volumen des aktiven Mediums 3 eines Oberflächenemitters 1 unterstützt eine schnelle interne Erwärmung. Die Laserdiode 1 kann, wie bereits erwähnt, alternativ auch lediglich oder zusätzlich durch ein externes Heiz- bzw. Kühlelement und/oder durch einen externen optischen Heiz-Impuls dauerhaft oder gepulst temperiert werden.

Eine Laserdiode 1 kann beispielsweise in der Lage sein, im statischen Betrieb eine Verschiebung aufgrund thermischer Effekte über einen Wellenlängenbereich von 10 nm abzudecken. Es wird jedoch nicht ausgeschlossen, dass stärkere temperaturabhängige Änderungen auftreten können. Eine elektrische Impulsform des elektrischen Impulses 10 ist derart zu wählen, dass eine spektrale Verbreiterung der optischen Impulse 2 durch eine Erwärmung hervorgerufen wird.

Die erwünschte Erwärmung eines elektrisch gepulsten Oberflächenemitters 1 entsteht überwiegend durch eine relativ hohe Verlustleistung überwiegend betreffend den Resonator 1a und ist somit insbesondere proportional zum angelegten Strom I. Da ein VCSEL 1 so konstruiert sein kann, dass im Dauerstrichbetrieb im Wesentlichen keine Erwärmung auftritt, können die verwendeten elektrischen Impulse 10 insbesondere Spannungen bzw. Ströme sein bzw. erzeugen, die über den von einem Hersteller empfohlenen Werte entsprechend einer Zerstörschwelle liegen. Vorzugsweise nimmt ein VCSEL 1 keine dauerhaften Schäden beim Betreiben oberhalb einer Zerstörschwelle, wenn beispielsweise geringe Repetitionsraten verwendet werden und dem VCSEL 1 damit genügend Zeit bleibt, um sich wieder abzukühlen bzw. thermisch zu regenerieren. In anderen Worten wurde gemäß der vorliegenden Erfindung erkannt, eine herkömmliche VCSEL Zelle zumindest bereichsweise außerhalb, besonders bevorzugt oberhalb der vom Hersteller angegeben Betriebsspannung und/oder zumindest bereichsweise außerhalb insbesondere oberhalb der vom Hersteller angegeben Betriebstemperatur zu betreiben, wobei ein gechirpter Laserimpuls erzeugt wird.

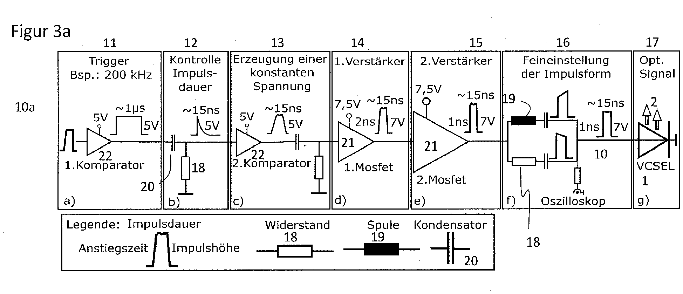

Ein beispielhafter elektrischer Impulsgenerator 10a bzw. eine elektrische Schaltung zur Erzeugung eines elektrischen Impulses 10, um einen optischen Impuls 2 mittels einer Laserdiode 1 zu erzeugen, wird in **Figur 3a** schematisch dargestellt.

Ein wesentlicher Bestandteil eines elektrischen Impulsgenerators 10a ist eine Schaltung, die den Betrieb der Laserdiode 1 bei hohen Spannungen oder Spannungsspitzen und möglicherweise schadhaft langen Impulsdauern unterbricht und damit die Laserdiode 1 elektrisch absichert. Im Wesentlichen sollte der elektrische Impulsgenerator 10a deshalb eine verlässliche Sicherung umfassen.

Die elektrische Schaltung des Frequenzgenerators 10a umfasst vorzugsweise, wie in **Figur 3a** dargestellt, einen Pulstrigger 11 bzw. einen Abschnitt 11 der Schaltung zum Triggern des elektrischen Impulses 10 (Abschnitt a), einen Abschnitt 12 der Schaltung zur Kontrolle über die Impulsdauer (Abschnitt b), einen Abschnitt 13 der Schaltung zum Erzeugen einer konstanten Spannung U (Abschnitt c), einen ersten Verstärker 14 (Abschnitt d), einen zweiten Verstärker 15 (Abschnitt e), sowie eine Feinabstimmung 16 (fine tuning) der Impulsform (Abschnitt f), die mit einem Ausgang 17 für die Emission von Laserimpulsen 2 umfassend die Laserdiode 1, vorzugsweise den Oberflächenemitter, der die optische Antwort generiert, elektrisch verbunden ist (Abschnitt g). Die Schnittstelle zwischen dem Frequenzgenerator 10a und der Laserdiode 1 befindet sich in **Figur 3a** entsprechend zwischen dem Abschnitt f) und dem Abschnitt g).

Elemente der Schaltung können dabei elektrische Widerstände 18, Induktoren bzw. Spulen 19, Kondensatoren 20, sowie MOSFETs bzw. Metall-Oxid-Halbleiter-Feldeffekttransistoren 21 sein. Es ist durchaus auch möglich, dass auf einen der Abschnitte a) bis g) verzichtet werden kann und/oder andere elektrische Bauteile hinzugefügt werden können. Die genannten Parameter des elektrischen Impulses 10 sind Werte, die bevorzugt werden, jedoch auch variiert werden können.

Die dargestellte Schaltung des Pulsgenerators 10a ist bevorzugt dazu ausgelegt, durch verschiedene Modifikationen, elektrische Impulse mit einer Dauer von vorzugsweise 2-15 ns bei Spannungen bis beispielsweise 30 V zu erzeugen und wobei die Steigung des Plateaus dabei leicht variiert werden kann.

In Abschnitt a) 11 kann die Repetitionsrate von beispielsweise 200 kHz von Rechteckimpulsen eines Frequenzgenerators vorgegeben werden. Es kann jedoch eine beliebige Repetitionsrate durchstimmbar beispielsweise zwischen 1 Hz und 10 MHz eingestellt werden. Es kann auch möglich sein, eine sich zeitlich ändernde Repetitionsrate einzustellen. Die hier genannten Repetitionsraten sind nur beispielhaft und können durchaus andere Werte annehmen bzw. innerhalb anderer Werte durchgestimmt werden. Der erste Komparator 22 schaltet auf eine feste Betriebsspannung von beispielsweise 5 V - sobald eine gewisse Spannung am Eingang erreicht wird, wird die Spannung unterschritten und so schaltet er wieder ab. Die Impulsdauer wird demnach zunächst durch die Dauer des Rechtecksignals des Frequenzgenerators 10a bestimmt. Ein Hochpass aus Kondensator 20 und Widerstand 18 in Abschnitt b) 12 erzeugt aus dem beispielsweise circa 1 $\mu$s langen Signal einen elektrischen Impuls, der nach schnellem Anstieg in wenigen beispielsweise in Nanosekunden abfällt. Die Zeit, bis das Signal auf 50% der Spannung abgefallen ist, wird durch die Kapazität des Kondensators 20 und einen regelbaren Widerstand 18 bestimmt. Mit einem zweiten Komparator 22 in Abschnitt c) 13 wird aus dem elektrischen Impuls mit langsam abfallender Flanke beispielsweise wieder ein Rechteckimpuls von einigen Nanosekunden generiert.

Die Impulsdauer ist also mit dem Widerstand 18 im Abschnitt b) regelbar. Durch die Verwendung eines weiteren Hochpasses wird garantiert, dass unter keinen Umständen elektrische Impulse 10 mit einer Dauer von beispielsweise mehr als 15 ns hindurchgelassen werden.

Dies kann beispielsweise für den Schutz bzw. die Sicherung einer (VCSEL-)Diode 1 essentiell sein.

Die zwei hintereinander geschalteten MOSFETs 21 (Metall-Oxid-Halbleiter-Feldeffekttransistor) in den Abschnitten d) und e) der beiden Verstärker 14, 15 verstärken die Impulse 10 und verkürzen die Dauer der Anstiegszeit schrittweise auf 2 ns und mit dem zweiten MOSFET 21 auf 1 ns. Über die an die MOSFETs 21 angelegte Spannung, welche proportional zur Spannung der erzeugten Impulse sein kann, wird die Amplitude geregelt. In dem Abschnitt f), der Feineinstellung der Impulsform 16 wird das Plateau der beispielsweise bis zu 15 ns langen und bis zu 30 V hohen Impulse geformt. Der elektrische Impuls 10 läuft dabei in einer Parallelschaltung über eine Spule 19 mit Kondensator 20 und einem regelbaren Widerstand 18 mit Kondensator 20. Damit wird beispielsweise an der Spule 19 eine leicht ansteigende und am Widerstand 18 eine abfallende Flanke erzeugt. Die Überlagerung ergibt vorzugsweise ein flaches Plateau dessen Anstieg durch Änderung des Widerstandes leicht manipuliert werden kann. Ferner kann eine negative Spannung im Bereich zwischen - 3 und -5 V schadhafte Auswirkungen auf den VCSEL haben, weshalb eine zu dem VCSEL antiparallel geschaltete Schutzdiode von der Schaltung umfasst werden kann. Eine solche Schutzdiode kann beispielsweise eine Spannung, welche an dem VCSEL anliegt auf -0,5 V begrenzen.

Mit der in der **Figur 3a** dargestellten Schaltung lassen sich elektrische Impulse bzw. Pulse erzeugen, die beispielsweise die folgenden Parameter aufweisen:

Repetitionsrate 1 Hz und 10 MHz, beispielsweise 200 kHz
Pulsdauer 5 bis 15 ns
Anstiegszeit: 1 bis 2 ns
Spannung: 6 bis 20 V
Temperaturkontrolle: 10 bis 50° C
Abstimmbarer Gradient

Die genannten Werte in der Beschreibung und in der **Figur 3a** sind beispielhaft und nicht beschränkend zu verstehen.

Insbesondere kann sich bei 200 kHz, was einer Zeitdauer bzw. der Dauer einer Periode von 5 $\mu$s entspricht, eine Laserdiode thermisch regenerieren, sich also auch ohne externen Thermostat wieder auf die Ausgangstemperatur abkühlen. Dies ist insbesondere für Frequenzen zwischen 1 kHz und 1 MHz der Fall.

Im Folgenden wird das Verhalten eines beispielhaften Oberflächenemitters 1 im statischen Betrieb betrachtet. Dazu wird zunächst eine Verschiebung der Wellenlänge durch eine statische Temperaturänderung untersucht. In anderen Worten wird ein Oberflächenemitter 1 bei unterschiedlichen Temperaturen im Gleichgewicht betrieben, um zu verdeutlichen, wie ein Spektrum eines emittierten optischen Impulses von der Temperatur abhängt. Zu diesem Zweck wird die Laserdiode 1 extern temperiert, z.B. durch einen Kühl- bzw. einen Heizkörper.

Es ist bekannt, dass Oberflächenemitter beispielsweise temperaturabhängige Änderungen der Wellenlänge im Bereich von 0,07 nm/°C für kurzwellig- (bis 1 μm) und 0,11 nm/°C für langwellig-emittierende (1,3 μm und 1,55 μm) Laserdioden im Dauerstrichbetrieb aufweisen.

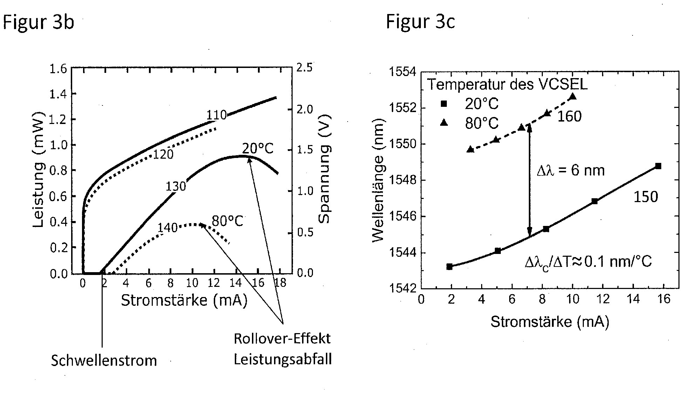

Auf sehr kurzen Zeitskalen von einigen Pikosekunden, also jenseits von einem Gleichgewichtszustand, kann, wie bereits erwähnt, eine starke Änderung des Injektions-Stroms beispielsweise eine Änderung im mittleren Brechungsindex hervorrufen und somit Einfluss auf die emittierte Wellenlänge nehmen. Eine Verschiebung der Zentralwellenlänge des Oberflächenemitters 1 auf langen Zeitskalen kann, wie bereits gesagt, aufgrund der Resonatorbedingung auch auf eine Erwärmung der Bragg-Schichtung zurückzuführen sein. Eine Erwärmung kann durch eine höhere Verlustleistung, die durch einen höheren Strom I erzeugt wird, erreicht werden oder durch eine externe Temperierung. In **Figur 3b** werden zwei beispielhafte Verläufe 130, 140 einer mittleren Leistung über dem angelegten Strom im Dauerstrichbetrieb für einen Oberflächenemitter dargestellt, ein Verlauf 130 bei 20°C und ein Verlauf 140 bei 80°C. Es ist der **Figur 3b** zu entnehmen, dass entsprechend der Kurve 130 bei 20 °C ein Schwellenstrom bei 1,38 mA liegt. In anderen Worten gesagt, beginnt die Laserdiode 1 elektromagnetische Strahlung zu emittieren ab einem Schwellenstrom von 1,38 mA. Ab etwa 12 mA setzt der sogenannte Rollover-Effekt ein, wobei die mittlere Leistung mit der Stromstärke nicht weiter steigt, sondern ein Plateau auftritt. Bei 80°C liegt der Schwellenstrom entsprechend der Kurve 140 über dem bei 20°C, etwa bei 2,8 mA und der Rollover-Effekt tritt schon bei niedrigeren Stromstärken I, etwa bei 9 mA auf. Es handelt sich hier um die Konsequenz aus der bereits erwähnten Verschiebung zwischen dem relativ breitbandigen Verstärkerspektrum und der relativ schmalbandigen Resonanz des Laserresonators.

Darüber hinaus bildet eine Kurve 110 den Spannungsverlauf der entsprechenden Laserdiode 1 in Abhängigkeit der Stromstärke bei 20°C ab und eine andere Kurve 120 bildet den Spannungsverlauf der entsprechenden Laserdiode 1 in Abhängigkeit der Stromstärke bei 80°C ab. Beide Kurven 110, 120 sind durch einen steilen Anstieg der Spannung bei geringen Stromstärken gekennzeichnet und durch eine im Wesentlichen linear ansteigende Spannung zu höheren Stromstärken.

Die Verschiebung der zentralen Wellenlänge eines durch eine Laserdiode 1 emittierten optischen Impulses 2 wird in diesem konkreten Fall zum größten Teil durch die Änderung des mittleren Brechungsindex der Bragg-Schichten 7, 8 hervorgerufen. Nur etwa 10% der Änderung wird in diesem Fall durch die Ausdehnung des Materials erzielt. Wie bereits erwähnt, wird neben der Bragg-Schichtung auch das aktive Medium 3 erwärmt. Dies führt weitestgehend beispielsweise zu einer Verkleinerung der Bandlücke und das relativ breite Verstärkungsspektrum verschiebt sich somit ebenfalls zu längeren Wellenlängen. Für kurzwellige Oberflächenemitter 1 (< 1 μm) kann beispielsweise die Wellenlängenänderung des Resonators bei 0,07 nm/K und die Verschiebung des Verstärkungsspektrums bei 0,32 nm/K liegen. Für langwellige Oberflächenemitter 1 (1,3 μm und 1,55 μm) können die Änderungen aufgrund anderer Materialien größer sein: beispielsweise für den Resonator 0,11 nm/K und für den Verstärker 0,5 nm/K.

**Figur 3c** zeigt, wie sich die Zentralwellenlänge des Spektrums des von der Laserdiode 1 emittierten optischen Impulses 2 im Dauerstrichbetrieb für eine feste Kühlkörpertemperatur in Abhängigkeit des angelegten Stroms I verschiebt. Es ergibt sich, wie in den Kurven 150, 160 der **Figur 3c** gezeigt, dass sich eine Zentralwellenlänge des von der Laserdiode 1 emittierten optischen Impulses 2 um mehr als 6 nm zu höheren Werten verschiebt, wenn die Temperatur von 20 °C auf 80 °C erhöht wird. Dies entspricht einem Quotienten von 0,1 nm/°C.

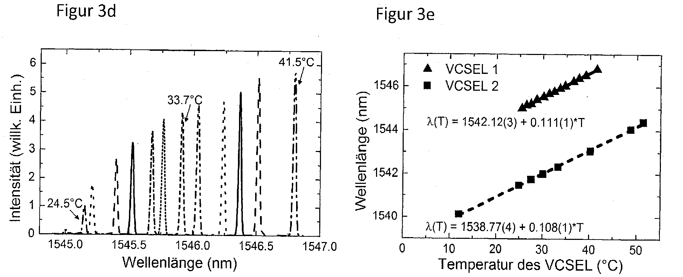

An dieser Stelle wird beispielhaft für zwei Oberflächenemitter 1 mit leicht unterschiedlicher Zentralwellenlänge der emittierten elektromagnetischen Strahlung die temperaturabhängige Wellenlängenverschiebung untersucht. Der erste beispielhafte Oberflächenemitter 1 wird dabei mit einem circa 300 ps langen elektrischen Impuls knapp über den Schwellenstrom betrieben. Temperaturen zwischen etwa 25°C und 42 °C werden am Kühlkörper eingestellt und gemessen. **Figur 3d** stellt die bei verschiedenen Temperaturen im Gleichgewicht aufgezeichneten beispielhaften Spektren dar. Die in der Figur markierten Spektren der emittierten elektromagnetischen Strahlung bei 41,5°C, bei 33,7°C und bei 24,5°C haben ihre jeweiligen zentralen Wellenlängen bei etwa 1546,8 nm, 1545,9 nm und 1545,2 nm.

Ein zweiter beispielhafter Oberflächenemitter 1 wird mit einem elektrischen Impuls 10 von etwa 1 ns Dauer und einer maximalen Spannungsamplitude von 9 V betrieben. In **Figur 3e** ist die Zentralwellenlänge der beiden beispielhaften Spektren über die Temperatur des Kühlkörpers der VCSEL Dioden aufgetragen. Für den ersten Oberflächenemitter 1 beträgt der Quotient der temperaturabhängigen Änderung der Wellenlängen 0,111 nm/°C und für den zweiten Oberflächenemitter 0,108 nm/°C.

Neben der Wellenlängenverschiebung sind in diesen Beispielen für die kurzen optischen Impulse nur knapp über dem Schwellenstrom Intensitätsunterschiede zwischen den Spektren in **Figur 3d** deutlich zu sehen. Diese Unterschiede hängen weitestgehend mit der relativen Verschiebung der Wellenlängen des Verstärkungsspektrums, zur Wellenlänge der Resonatormode zusammen. Demnach ist der Ursprung eines Intensitätsanstieges bei konstantem Strom I, die Änderung des Schwellenstroms (siehe **Figur 3b**), welcher sich mit steigender Temperatur ändert.

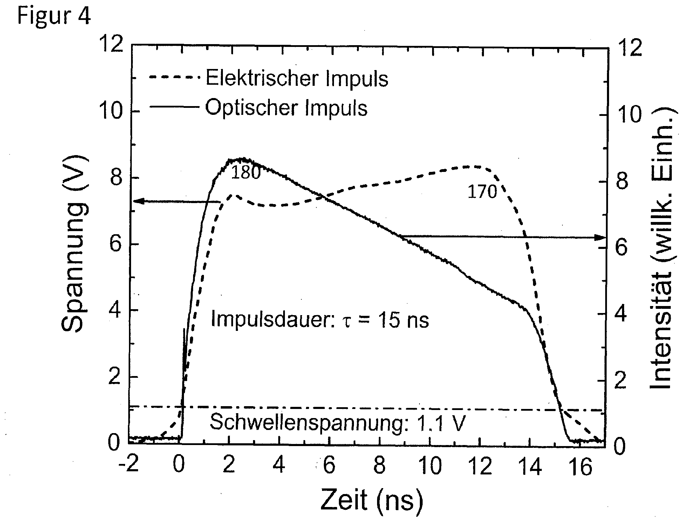

**Figur 4** zeigt ein Diagramm für den zeitlichen Verlauf 170 eines elektrischen Impulses 10, der eine Laserdiode 1 erreicht bzw. von einem Impulsgeber 10a erzeugt und bereitgestellt wird, im direkten Vergleich mit dem zeitlichen Verlauf 180 eines von der Laserdiode 1 emittierten optischen Impulses 2. Auf der Abszisse ist die Zeit in ns aufgetragen. Auf der linken Ordinate wird die Spannung in V aufgetragen. Die linke Ordinate bezieht sich auf den elektrischen Impuls 10, der hier als Spannungsimpuls dargestellt ist. Alternativ könnte auch der zeitliche Verlauf eines angelegten Stroms I bzw. eines Stromimpulses aufgetragen werden.

Die rechte Ordinate bezieht sich auf die normierte Intensität des optischen Impulses 2. Der elektrische und der optische Impuls haben jeweils eine Impulsdauer von etwa 15 ns. Über die Zeitdauer eines elektrischen Impulses erwärmt sich die Laserdiode 1 bzw. das optisch aktive Medium 3.

In einem anderen Beispiel konnte gezeigt werden, dass bei einer elektrischen Impulsdauer (hier wird eine Halbwertsbreite als Maß für eine Impulsdauer angegeben, FWHM) von 8,4 ns und einer maximalen Spannung des Spannungspulses von 16,3 V, (mittlere Spannung 12,5 V) eine VCSEL-Diode 1 einen 8,5 ns langen (FWHM) optischen Impuls 2 emittiert dessen Spektrum eine Bandbreite von etwa 5,53 nm aufweist. Aus dem temperaturabhängigen Verhalten der VCSEL-Diode im statischen Betrieb kann daher angenommen werden, dass sich die VCSEL-Diode um etwa 50°C während der Dauer des elektrischen Impulses erwärmt.

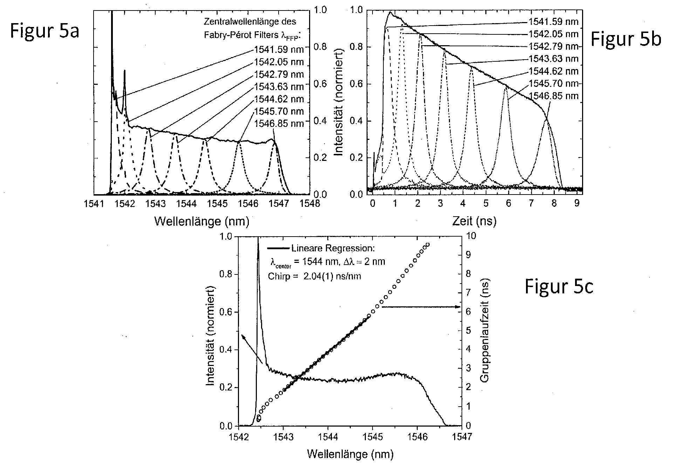

Mit einem verstellbaren bzw. einstellbaren Fabry-Pérot-Filter (beispielsweise mit einer Bandbreite des Lorentz-Profils von 0,325 nm) kann beispielsweise geprüft werden, welche Wellenlängen zu welchen Zeiten in einem optischen Impuls 2 mit einer Dauer von 8,5 ns auftreten. **Figur 5a** zeigt beispielhaft sieben Spektrenanteile aus dem Impulsspektrum bzw. Spektrum des optischen Impulses, welche einen auf die jeweilige Wellenlänge eingestellten Fabry-Pérot-Filter passieren. Der Filter ist auf sieben unterschiedliche Zentralwellenlängen zwischen 1541,59 nm und 1546,85 nm eingestellt.

In **Figur 5b** ist beispielhaft ein zeitlicher Verlauf eines optischen Impulses mit den dazugehörenden Intensitäten der sieben bereits in Figur 5a gezeigten Spektralanteile, die der Filter an den verschiedenen Positionen durchlässt bzw. passieren lässt, zu sehen. Es wird in anderen Worten eine zeitliche Wellenlängen-(Rot-)Verschiebung innerhalb eines optischen Impulses 2 mittels eines einstellbaren Fabry-Pérot-Filters verbildlicht. Die zeitliche Verschiebung kann an einem Oszilloskop direkt gemessen werden, da der Impulsgenerator 10a der (VCSEL-)Diode durch das Oszilloskop getriggert werden kann. Mit dem Fabry-Pérot-Filter ist deutlich zu sehen, dass in diesem Beispiel Licht kleinerer Wellenlängen zeitlich vor Licht längerer Wellenlängen emittiert wird. Das Lorentz-Profil des Fabry-Pérot-Filters nimmt auch den zeitlichen Verlauf des gefilterten Signals an und lässt in diesem Fall auf eine zeitlich gleichmäßige Änderung der Wellenlänge schließen.

Für etwa 40 Filter-Positionen bzw. Zentralwellenlängen der jeweiligen Filter werden die Spektren und der zeitliche Intensitätsverlauf hinter dem Fabry-Pérot-Filter über ein 50/50-Strahlteiler jeweils gleichzeitig aufgenommen. Die zeitliche Verzögerung des Signals entsprechend der jeweiligen Wellenlängen ist in dem Diagramm der **Figur 5c** beispielhaft über die Zentralwellenlänge der jeweiligen Filter-Position aufgetragen. Auf der rechten Ordinate ist die Gruppenlaufzeit bzw. zeitliche Verzögerung (Engl.: group delay) in ns gegen die Wellenlänge in nm auf der Abszisse aufgetragen.

**Figur 5c** stellt ferner das Wellenlängenspektrum des optischen Impulses mit Bezug zur linken Ordinate dar. Auf der linken Ordinate ist deshalb die auf das Spektrum bezogene normierte Intensität aufgetragen.

Es wurde beispielhaft ein Fit über eine Wellenlängendifferenz von 2 nm an die ausgewählten Gruppenlaufzeit-Messpunkte eines linearen Bereichs im Intervall zwischen 1543 nm und 1545 nm angelegt. In anderen Worten wurden die Parameter einer Funktion an die aufgetragenen Datenpunkte entsprechend der Gruppenlaufzeiten angepasst. Bei dem Fit handelt es sich um eine lineare Gerade, deren Steigung einem Wert für den Chirp entspricht, die hier in diesem Fall etwa 2 ns/nm beträgt. Dies bedeutet, dass innerhalb eines optischen Impulses 2 eine Wellenlänge, die sich um einen nm von einer anderen unterscheidet entweder dieser Wellenlänge um etwa 2 ns vorauseilt oder hinterherläuft. Dies gilt mindestens für den Bereich, der (offensichtlich) einer linearen Abhängigkeit zwischen Verzögerung und Wellenlänge unterliegt. Der lineare Verlauf für den elektrischen Impuls 2 ist besonders hervorzuheben, da dieser darauf schließen lässt, dass sich die Laserdiode 1, im vorliegenden Fall die VCSEL-Diode 1 sehr gleichmäßig bzw. überwiegend linear mit der Zeit erwärmt.

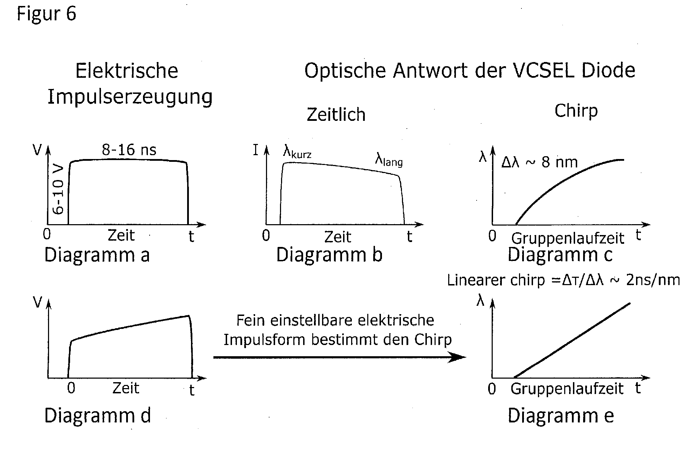

**Figur 6** umfasst die Diagramme a bis e, die schematisch und beispielhaft veranschaulichen sollen, wie die zeitliche Form eines elektrischen Impulses 10 einen Chirp bestimmt. Zunächst wird in Diagramm a beispielhaft ein überwiegend kastenförmiger elektrischer bzw. in diesem Fall ein Spannungsimpuls von 8 bis 16 ns dargestellt. Der elektrische Impuls erreicht Werte von 6 bis 10 V.

Ein solcher elektrischer Impuls 10 kann dazu führen, wenn er an einen Oberflächenemitter 1 angelegt wird, dass der Oberflächenemitter 1 einen optischen Impuls 2 emittiert mit der zeitlichen Intensität bzw. Form entsprechend des in dem Diagramm b gezeigten zeitlichen Verlaufs. Im vorliegenden Beispiel eilt eine kurze Wellenlänge einer längeren Wellenlänge innerhalb eines optischen Impulses 2 voraus bzw. eine kürzere Wellenlänge tritt früher in einem zeitlichen Verlauf eines optischen Impulses 2 auf als eine längere. Dies bedeutet, dass der optische Impuls 2 einen negativen Chirp aufweist. Die Intensität ist weitestgehend kastenförmig und weist einen geringen zeitlichen Abfall auf.

Die zeitliche Verzögerung von Wellenlängen gegeneinander bzw. die Gruppenlaufzeit ist in Diagramm c dargestellt. Die Kurve unterliegt in diesem Beispiel keiner linearen Abhängigkeit. Die zentralen Wellenlängen des von einer Laserdiode 1 emittierten optischen Impulses 2, die durch einen elektrischen Impuls 10 gemäß Diagramm a ausgelöst wurden, sind also zeitlich nicht linear gegeneinander verzögert bzw. verschoben, deshalb liegt in diesem beispielhaften Fall kein linearer Chirp vor.

Erst ein elektrischer Impuls 10, dessen Spannungsverlauf beispielsweise dem des Diagramms d entspricht, also kein Plateau bei einem maximalen Spannungswert, sondern einen zeitlichen leichten Anstieg verzeichnet, kann einen optischen Impuls 2 mit einem linearen Chirp erzeugen. Die zentralen Wellenlängen des von einer Laserdiode 1 emittierten optischen Impulses 2 sind zeitlich in dem Diagramm linear gegeneinander verschoben bzw. verzögert. Derart lässt sich der Chirp bzw. die Art, nach der die zentralen Wellenlängen des von einer Laserdiode 1 emittierten optischen Impulses 2 gegeneinander zeitlich verschoben sind, durch den elektrischen Impuls abstimmen.

Es wird dennoch nicht ausgeschlossen, dass in einzelnen Fällen beispielsweise in Abhängigkeit der Bauweise einer VCSEL-Diode, ein linearer Chirp durch eine andere elektrische Impulsform erzielt werden kann.

Der elektrische Impuls, welcher die VCSEL-Diode betreibt und erwärmt sollte die VCSEL-Diode nur bis zu einer bestimmten maximalen Temperatur erwärmen, um die VCSEL-Diode nicht dauerhaft zu beschädigen. Diese Maximaltemperatur, bei der Schäden auftreten können, ist für unterschiedliche Laserdioden unterschiedlich hoch. Beispielsweise kann eine solche Maximaltemperatur bei 120°C liegen. Beispielsweise kann eine Maximaltemperatur einer exemplarischen Laserdiode erreicht werden, indem ein elektrischer Impuls von etwa 2-5 ns Dauer und einem Maximalwert von 30-50 V an die Laserdiode angelegt wird. Diese Maximaltemperatur der exemplarischen Laserdiode kann jedoch auch dadurch erzielt werden, dass ein elektrischer Impuls von etwa 30 ns Dauer und einem Maximalwert von nur 8 V an die Laserdiode angelegt wird.

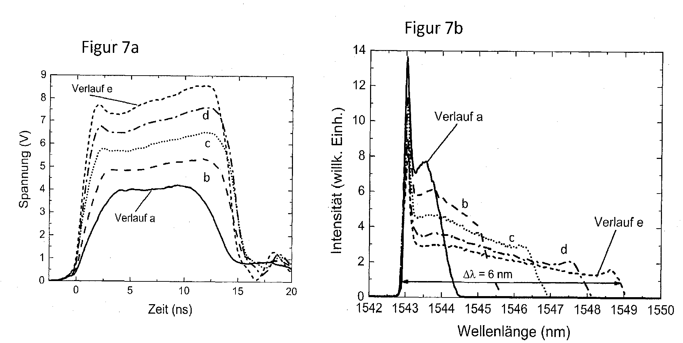

In **Figur 7a** sind beispielhaft fünf verschiedene zeitliche Verläufe (Verlauf a - Verlauf e) elektrischer Impulse 10 zu unterschiedlichen erreichten maximalen Spannungen U dargestellt. Der beispielhafte Verlauf a, der in seinem Plateaubereich eine Spannung von etwa 4 V erreicht, steht Verläufen mit höheren maximalen Spannungen entgegen, beispielsweise Verlauf e, welcher eine maximale Spannung von etwa 8 - 8,5 V in seinem Plateaubereich erreicht. Verlauf a weist ferner eine etwas kürzere Impulsdauer als Verlauf e auf.

**Figur 7b** zeigt beispielhaft fünf optische Spektren der optischen Impulse 2, die durch elektrische Impulse jeweils entsprechend den Verläufen a) - e) in **Figur 7a** mittels einer VCSEL-Diode erzeugt werden. Ein elektrischer Impuls 10 entsprechend des Verlaufs e in **Figur 7a** erzeugt demnach einen optischen Impuls 2 mit einer spektralen Bandbreite von etwa 6 nm entsprechend des Verlaufs e in **Figur 7b**. Der Verlauf a in **Figur 7a** erzeugt hingegen einen optischen Impuls 2 mit einer schmaleren Bandbreite von etwa 1 nm entsprechend des Verlaufs a in **Figur 7b.** Da eine höhere Spannung U eines elektrischen Impulses 10 zu einer höheren Temperaturdifferenz führt, emittiert die Laserdiode 1 entsprechend ein breiteres Spektrum an Wellenlängen, wie aus den **Figuren 7a** und **7b** zu erkennen ist. Wie bereits erwähnt, darf jedoch die maximale Temperatur zum Schutz der Laserdiode 1 nicht überschritten werden. Es kann beispielsweise auch ein elektrischer Impuls mit einer maximalen Spannung von 31,5 V und einer Dauer von 7 ns an eine exemplarische Laserdiode 1 angelegt werden, wodurch ein optischer Impuls mit einer spektralen Breite von 7,37 nm und einem Chirp von etwa 0,9 ns/nm entsteht. Es kann beispielsweise alternativ auch ein elektrischer Impuls mit einer maximalen Spannung von 12,5 V und einer Dauer von 15 ns an eine exemplarische Laserdiode 1 angelegt werden, wodurch ein optischer Impuls mit einer spektralen Breite von 9,12 nm und einem Chirp von etwa 1,6 ns/nm entsteht.

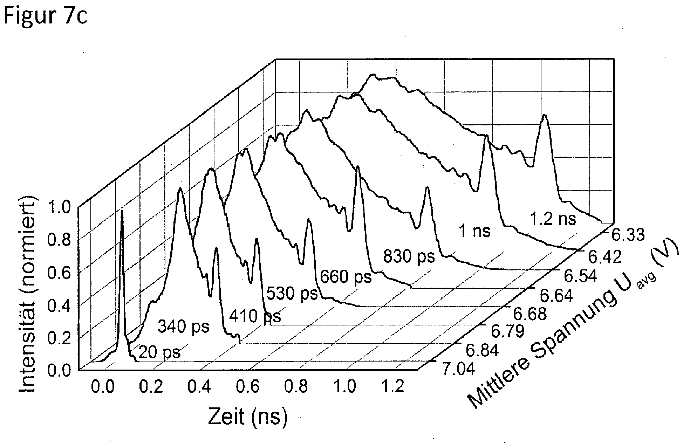

**Figur 7c** stellt ein beispielhaftes Diagramm dar, welches acht verschiedene zeitliche Verläufe optischer Impulse nach dem Durchlaufen eines gechirpten Faser-Bragg-Gitters zu jeweils acht elektrischen Impulsen 10 zeigt. Dabei werden durchschnittliche Spannungen von 7,04, 6,84, 6,79, 6,68, 6,64, 6,54, 6,42 und 6,33 V angelegt. Es ergeben sich entsprechend optische Impulse mit einer Dauer (FWHM) von 20, 340, 410, 530, 660, 830 ps und 1 und 1,2 ns entsprechend der jeweiligen elektrischen Impulse. Demnach entstehen kürzere optische Impulse durch höhere mittlere und/oder maximale Spannungen U der elektrischen Impulse, da sich der intrinsische Chirp des von der VCSEL-Diode emittierten optischen Impulses mit steigender Spannung der Dispersion des Kompressors anpasst, der im konkreten Fall ein gechirptes Faser-Bragg-Gitter umfasst und zusätzlich als Selektor dient.

Insbesondere kann eine Erhöhung einer Spannung U eines elektrischen Impulses bzw. der Spannung U, die an eine Laserdiode 1 angelegt wird, zu einer schnelleren Erwärmung der Laserdiode 1 führen, was wiederum zu einer schnelleren Wellenlängenverschiebung der zentralen Wellenlänge des Spektrums des emittierten optischen Impulses und demnach zu einem geringeren Chirp führt. In anderen Worten hängt das Maß des Chirps von der Geschwindigkeit der instantanen Wellenlänge des Spektrums des emittierten optischen Impulses 2 und demnach von der Geschwindigkeit der Erwärmung der Laserdiode 1 und entsprechend von der Amplitude der angelegten Spannung U und der entsprechenden Stromstärke I ab.

Experimente haben gezeigt, dass eine Verbreiterung der Spektren insbesondere durch eine Erwärmung auf einer Zeitskala von einigen Nanosekunden stattfindet. Größere Spannungsamplituden versprechen eine schnellere Erwärmung und somit einen kleineren Chirp, der für eine mögliche Kompression der Impulse benötigt werden kann.

Demnach kann das Erhöhen einer angelegten Spannung U einen geringeren Chirp des optischen Impulses 2 bewirken. Zur Kontrolle über die Bandbreite dient dann die Dauer des elektrischen Impulses 10. Wird eine längere Dauer eines elektrischen Impulses 10 gewählt, so kann die Bandbreite des optischen Impulses 2 und entsprechend die Impulsdauer vergrößert werden.

Die **Figur 8a** stellt schematisch beispielhaft dar, wie eine Laserdiode 101, insbesondere ein Oberflächenemitter 101 in ein Lasersystem 100 integriert sein kann. Der Oberflächenemitter 101 dient dazu, einen optischen Impuls 2 zu emittieren, welcher durch das System 100 weiter verstärkt und komprimiert wird, sodass ein ultrakurzer Laserimpuls 102 generiert werden kann. Dabei besteht insbesondere nicht die Notwendigkeit zum Einsatz konventioneller Mittel, wie beispielsweise einer Güteschaltung und/oder einer Modenkopplung. Die Laserdiode 101 erzeugt dabei einen optischen Impuls 2, der anderer Elemente derart durchläuft, dass am Ausgang des Systems 100 ein sehr kurzer intensiver optischer Impuls 102 mit einem vorbestimmten Wellenlängenspektrum emittiert wird. Das Lasersystem 100 umfasst hier zum Beispiel neben der Laserdiode 101 einen regelbaren elektronischen Pulsgenerator 10a, bzw. einen Frequenzgeber, der die entsprechenden elektrischen Impulse 10 an die Laserdiode 101 anlegen kann. Der Pulsgenerator 10a kann dabei beispielsweise eine Spannung U regeln und/oder steuern, welche einen Strom I durch eine Laserdiode 101 bewirken kann, oder einen Strom I durch die Laserdiode 101 regeln und/oder steuern. Dabei ist es bevorzugt, wenn sich der Pulsgenerator 10a derart einstellen lässt, dass eine durchstimmbare Frequenz, Impulsdauer, Intensität, Repetitionsrate, sowie Form des elektrischen Impulses 10 auswählen bzw. einstellen lässt.

Die Laserdiode 101 emittiert als optische Antwort einen optischen Impuls 2, der in dem beispielhaften System 100 einen optischen Vorverstärker 103 passiert bzw. durchläuft. Darin wird der optische Impuls 2 in seiner Intensität zunächst verstärkt. Der optische Vorverstärker 103 umfasst vorzugsweise einen Erbium-dotierten Faserverstärker. Der optische Vorverstärker 103 kann alternativ auch einen Ytterbium- und/oder einen Thulium-dotierten Faserverstärker umfassen.

Im Anschluss kann der optische Impuls 2 in dem beispielhaften System 100 ein Selektionselement 106 durchlaufen, in dem ein vorbestimmter Wellenlängenbereich selektiert wird. Das Selektionselement 106 kann vorzugsweise ein Faser-Bragg-Gitter umfassen bzw. sein, welches einen vorbestimmten Wellenlängenbereich passieren lässt bzw. herausfiltert bzw. herausschneidet. Alternativ könnte ein Selektionselement auch einen optischen Filter und/oder ein dispersives Element, beispielsweise ein optisches Gitter und/oder eventuell eine Blende zur Selektion umfassen.

Nach der Selektion eines vorbestimmten Wellenlängenbereichs kann der optische Laserimpuls 2 einen weiteren optischen Verstärker 104, insbesondere einen Hauptverstärker 104 durchlaufen, der dazu ausgelegt ist, den Laserimpuls 2 wesentlich in seiner Intensität zu verstärken. Vorzugsweise umfasst auch der Hauptverstärker 104 einen Erbium-dotierten Faserverstärker. Die Verstärkung basiert dabei im Wesentlichen auf dem Prozess der stimulierten Emission des Lasermediums des Erbium-dotierten Faserverstärkers, wobei der gepulste Laser, also die Laserdiode als "seed laser" bzw. Anregungslaser die stimulierte Emission bewirkt.

Nach Verstärken des Laserimpulses 2 kann dieser einen Kompressor 105 durchlaufen. Der Kompressor dient dazu, die Verzögerung der Wellenlängen eines gechirpten Laserimpulses 2 zu vermindern und insbesondere im Wesentlichen auszulöschen, sodass der Laserimpuls 2 eine starke Komprimierung erfährt. Der Kompressor 105 umfasst bevorzugt ein Volumen-Bragg-Gitter mit einer festen materialbezogenen Dispersion, insbesondere eine chromatische Dispersion. Für hohe Impulsenergien erfolgt die Kompression bevorzugt durch einen Freistrahl-Kompressor, um einen vergleichsweise breiten Laserstrahl bezüglich des Strahl- bzw. Modendurchmessers passieren zu lassen, wodurch die Energiedichte des Laserstrahls gering gehalten werden kann.

Ein besonderer Kompressor 105, beispielsweise in Form eines gechirpten Faser-Bragg-Gitters kann beispielsweise auch gleichzeitig als Kompressor 105 und Selektionselement 106 genutzt werden. Ein solcher Kompressor 105 wird von dem Laserstrahl vorzugsweise nach Passieren des optischen Vorverstärkers 103 durchlaufen.

Ein beispielhaftes System, welches schematisch in **Figur 8a** dargestellt ist, kann vorzugsweise Laserimpulse von einer Dauer zwischen 5 ps und 100 fs, von Energien bis zu 10 $\mu$J und von Repetitionsraten zwischen 1 kHz und 1 MHz erzeugen. Beispielsweise hat ein Laserimpuls 2, welcher von dem beispielhaften Lasersystem 100 erzeugt wurde, eine Dauer von etwa 3,5 ps und eine Energie von etwa 1 $\mu$J bei einer Repetitionsrate von etwa 200 kHz.

In der Optik ist im Allgemeinen die Dispersion das Phänomen, in dem die Phasengeschwindigkeit einer Welle, welche ein Material durchquert, von ihrer Frequenz abhängt. Medien, die diese gemeinsame Eigenschaft haben, können als dispersive Medien bezeichnet werden. Dispersion tritt insbesondere auch in optischen Fasern auf. In der Optik ist eine wichtige Auswirkung der Dispersion die Veränderung des Brechungswinkels verschiedener Lichtfarben, wie sie im Spektrum eines dispersiven Prismen und der chromatischen Aberration von Linsen auftritt. Dies kann beispielsweise zu Gangunterschieden unterschiedlicher Wellenlängen führen. Bei einigen Anwendungen ist die absolute Phase einer Welle nicht von wesentlichem Interesse, sondern nur die Ausbreitung von optischen Impulsen. In diesem Fall interessiert man sich nur für Variationen der Gruppengeschwindigkeit mit der Frequenz, die sogenannter Gruppen-Geschwindigkeits-Dispersion, d.h. der group velocity dispersion (kurz: GVD).

Am häufigsten bezieht sich eine sogenannte chromatische Dispersion auf die Bulk-Material-Dispersion, das heißt, die Änderung des Brechungsindexes mit der optischen Frequenz in einem Volumen eines Materials. Jedoch gibt es in einem Wellenleiter auch das Phänomen der Wellenleiterdispersion, wobei in diesem Fall die Phasengeschwindigkeit einer Welle in einer Struktur von ihrer Frequenz einfach aufgrund der Geometrie der Struktur abhängt. Im Allgemeinen kann eine "Wellenleiter"-Dispersion für Wellen auftreten, die sich durch irgendeine inhomogene Struktur (z.B. einen photonischen Kristall) ausbreiten, unabhängig davon, ob die Wellen auf irgendeine Region beschränkt sind oder nicht. In einem Wellenleiter sind beide Arten von Dispersionen im Allgemeinen vorhanden, obwohl sie nicht unbedingt additiv sind. Beispielsweise kann es unter bestimmten Umständen vorkommen, dass bei einer Faseroptik die Material- und die Wellenleiterdispersion sich gegenseitig aufheben, um eine Wellenlänge von Nulldispersion zu erzeugen.

**Figur 8b** stellt eine bevorzugte Ausführungsform eines Lasersystems 100 dar, welche zu einem großen Teil aus Faser-Elementen besteht. Ein experimenteller Aufbau zur Demonstration der Funktionsweise der CFBGs setzt sich aus den in **Figur 8b** dargestellten Komponenten (VCSEL 101, Polarisationskontrollelement umfassend einen Polarisationsteller und einen Polarisationsteiler, Er:Faser-Verstärker 104, sowie gechirpte Faser-Bragg-Gitter 105/106 mit Zirkulator) zusammen. Ein Er:FaserVerstärker 104 stellt im Wesentlichen ein optischer Faserverstärker, bei dem als aktives Medium eine mit Erbium dotierte Faser verwendet wird, dar.

Das System 100, welches in der **Figur 8b** dargestellt ist, unterscheidet sich von dem der **Figur 8a** insofern, als dass vor dem ersten Verstärkerelement ein Modul zur Kontrolle der Polarisation eingebaut ist. Ferner findet in **Figur 8b** ein Selektionsschritt während einer gleichzeitigen optischen Kompression, insbesondere einer Vorkompression statt, wohingegen in dem System 100 der **Figur 8a** ein von der Kompression örtlich und zeitlich getrennter Selektionsschritt, insbesondere vor dem Verstärken stattfindet. In dem System 100 der **Figur 8b** wird nach dem Polarisationselement das Signal in einem Er:Faser-Verstärker 104 verstärkt bevor es in das gechirpte Faser-Bragg-Gitter 105/106 gelangt. Im Anschluss passiert der optische Impuls den Hauptverstärker, ein zweiter Er:Faser-Verstärker 104, sowie ein gechirptes Volumen-Bragg-Gitter, das im Wesentlichen als Hauptkompressor dient, bevor das "Endprodukt" des Laserimpulses das System 100 verlässt. Eine Kombination von Merkmalen beider Systeme aus **Figur 8a** und **Figur 8b** ist ebenfalls möglich. Das System umfasst ferner einen verstellbaren Pulsgenerator 10a mit Thermostat, hier als Peltier-Element dargestellt, und eine VCSEL-Diode 101.

Im Folgenden wird die Kompression der gechirpten und verstärkten Laserimpulse genauer betrachtet.

Wie bereits erwähnt ist eine relativ langsame Erwärmung der VCSEL-Diode 1 während eines elektrischen Impulses 10 weitestgehend für die Verbreiterung des Wellenlängenspektrums verantwortlich. Die Dauer der Impulse liegt damit bei einigen Nanosekunden. Eine beispielhafte VCSEL-Diode 1 und auch andere Halbleiterdioden können solche Impulsdauern auch im Normalbetrieb erreichen. Der Unterschied ist die Breite des Spektrums, die es theoretisch ermöglicht, den optischen Impuls 2 auf das Fourier-Limit von wenigen Picosekunden zu komprimieren. Durch eine Verstärkung und Kompression der optischen Impulse 2 kann die Intensität stark erhöht werden und erreicht damit interessante Bereiche für viele Anwendungsgebiete. Die Kompression der optischen Impulse 2, die von einer elektrisch gepumpten VCSEL-Diode 1 erzeugt werden, nahe an das Fourier-Limit, ist essentiell in der Entwicklung von Lasersystemen, die ohne Modenkopplung auskommen können.

Wenn ein gechirptes Faser-Bragg-Gitter (CFBG) mit einer Länge von 1 m bereitgestellt wird, dann kann ein optischer Impuls mit einer Dauer von 10 ns komprimiert werden, wobei $t = 2*L/(c*n)$ gilt (L = Länge der Faser, c = Lichtgeschwindigkeit, n = mittlerer Brechungsindex der Faser, t = maximal komprimierbare Impulsdauer).

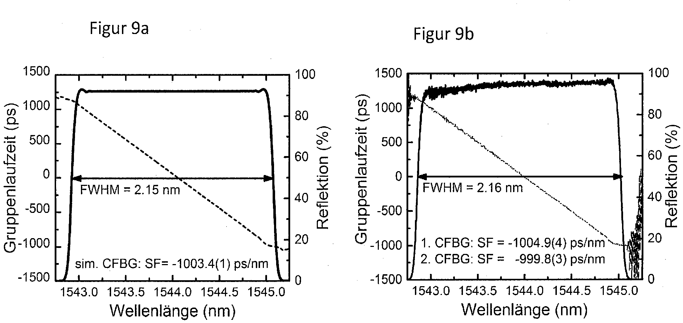

Mit zwei gechirpten Faser-Bragg-Gittern mit einer beispielhaften zentralen Wellenlänge von 1544 nm, einer Filterbreite von 2 nm und einem Streckungsfaktor von je -1000 ps/nm werden Versuche beispielhaft zur Komprimierung der optischen Impulse vorgestellt. Die Reflektivität und die Gruppenlaufzeit sind in **Figur 9a** dargestellt. Die Simulation des Herstellers für ein solches gechirptes Faser-Bragg-Gitter gemäß **Figur 9a** erreicht einen Streckungsfaktor von -1003,4 ps/nm über den Wellenlängenbereich von etwa 1543 nm bis 1545 nm. **Figur 9b** zeigt die vom Hersteller aufgenommenen Messdaten. Die gemessenen Datenpunkte eines realen Gitters weichen demnach nicht Wesentlich von der Simulation ab.

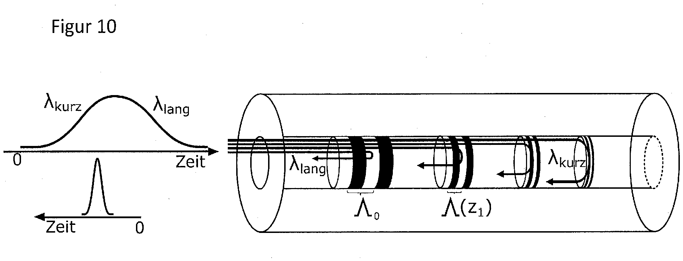

**Figur 10** stellt schematisch die Funktionsweise eines gechirpten Faser-Bragg-Gitters dar. Eine Wellenlänge λ wird bei senkrechtem Einfall an einer Bragg-Schichtung reflektiert, wenn die Schichtdicke 1/4 der Wellenlänge beträgt (Gitterperiode entspricht 1/2 der Wellenlänge: λ= 2*effektiver Brechungsindex*Gitterperiode). Die Schichtdicke bzw. Gitterperiode in einem gechirpten Faser-Bragg-Gitter variiert in Propagationsrichtung des optischen Impulses. Somit werden die einzelnen Wellenlängenkomponenten des optischen Impulses an unterschiedlichen Stellen bzw. Eindringtiefen in der Faser reflektiert und erfahren deshalb einen Gangunterschied bzw. eine Verzögerung gegenüber anderen Wellenlängen.

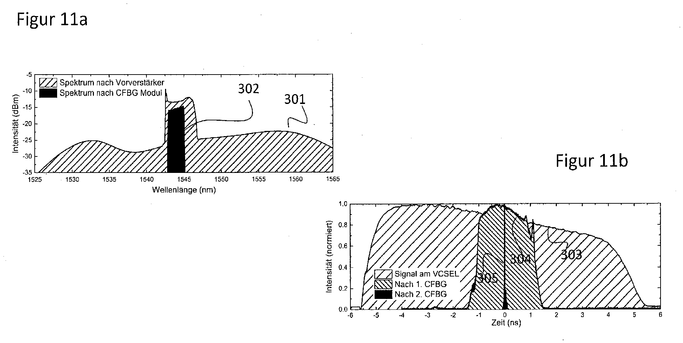

**Figur 11a** stellt beispielhaft das Spektrum 301 nach einem, wie in **Figur 8b** dargestellten, beidseitig gepumpten ersten Vorverstärker 104 (erster Er:FaserVerstärker 104) dar. **Figur 11a** stellt auch das Spektrum 302 nach den beiden gechirpten Faser-Bragg-Gittern (105/106) gemäß der entsprechenden Verstärker aus **Fi-**

**gur 8b** dar. Die Intensität wird dabei logarithmisch aufgetragen, damit die Anteile der Intensität, die auf eine verstärkte spontane Emission, kurz ASE, von einer Erbium-dotierten Faser zurückgehen, in diesem Spektrum, zwischen 1525 und 1570 nm, insbesondere zwischen 1530 und 1535 nm sichtbar ist.

Eine Kombination aus schwachem Eingangs-Signal, schmaler Bandbreite und kleiner Repetitionsrate von beispielsweise 200 kHz kann dazu führen, dass sich im ASE-Spektrum, bei zu starkem Pumpen, spontane Lasermoden zwischen 1530 nm und 1535 nm ausbilden, welche in der **Figur 11a** nicht gezeigt werden. Die damit verbundenen starken Leistungsschwankungen der ASE verhindern eine gleichmäßige Verstärkung des Eingang-Signals und sind deshalb zu vermeiden und ein entsprechender spektraler Bereich ist deshalb aus dem selektierten Bereich auszuschließen. Das gechirpte Faser-Bragg-Gitter ist in der Lage, einen solchen Bereich auszuschließen. Deshalb übernimmt in dem Lasersystem 100, wie es beispielsweise der **Figur 8b** zu entnehmen ist, gleich mehrere Funktionen, nämlich zumindest teilweise die der Kompression und die der Selektion.

Ferner umfasst das Spektrum 301 des von der Laserdiode 1 emittierten optischen Impulses 2 mindestens eine Intensitätsspitze bzw. eine überhöhte Intensität zwischen 1542,5 und 1543,5 nm, insbesondere bei etwa 1542,8 bis 1543,4 nm. Dieser Bereich des Wellenlängenspektrums liegt typischerweise bei niedrigen Wellenlängen des Spektrums des von der Laserdiode 1 emittierten optischen Impulses 2. Typischerweise liegt der zur Selektion vorbestimmte Wellenlängenbereich überwiegend bei Wellenlängen, die höher sind als das der überhöhten Intensität, also > 1543 nm. Dieser Wert hängt jedoch stark von der individuellen Laserdiode 1 und deren Betriebstemperatur ab. Idealerweise und bevorzugt wird ein Spektrum 302 derart aus dem Spektrum 301 eines emittierten optischen Impulses heraus selektiert, dass die Intensitätsspitze bzw. die überhöhte Intensität bei etwa 1543 nm und entsprechend die überhöhte Energie aus der Selektion ausgeschlossen bzw. herausgefiltert bzw. ausgeschnitten bzw. unterdrückt wird. Der auszuschließende Wellenlängenbereich weist allgemein mindestens eine überhöhte Intensität, die wesentlich von den Intensitäten anderer Wellenlängen abweicht. In dem Spektrum 301 eines emittierten Laserimpulses der **Figur 11a** kann man deutlich erkennen, wie mindestens eine überhöhte Intensität bei etwa 1543 nm von den Intensitäten überwiegend in dem Bereich der Wellenlängen zwischen etwa 1544 bis 1545 nm abweicht, insbesondere im Hinblick auf die logarithmische Auftragung. Dieser Bereich zwischen etwa 1544nm und 1545 nm kann beispielsweise vorteilhaft für weitere Verfahrensschritte aus dem Spektrum 301 so selektiert d.h. gefiltert werden, dass ein selektiertes Spektrum 302, wie in **Figur 11 a** beispielhaft dargestellt für weitere Schritte gewählt wird.

Zum einen werden von dem Gitter beispielhaft im Wesentlichen nur die Teile des Impulsspektrums reflektiert, die einen überwiegend linearen Chirp besitzen und durch den Streckungsfaktor des Gitters werden die reflektierten Komponenten des optischen Impulses 2 direkt komprimiert. Zum anderen werden alle anderen Wellenlängenkomponenten transmittiert und gelangen nicht zurück in den Zirkulator. Das führt dazu, dass ein vorbestimmter Wellenlängenbereich, insbesondere ohne eine überhöhte Intensität bzw. Intensitätsspitzen, insbesondere bei etwa 1543 nm, aus dem breiten ASE-Spektrum des Verstärkers nach den CFBGs selektiert und weiterverwendet werden kann.

Ein nicht gechirptes Faser-Bragg-Gitter mit einer beispielhaften Bandbreite von 2,2 nm würde von dem optischen Impuls, der beispielsweise einen linearen Chirp von 2 ns/nm aufweist, ein Signal mit einer Dauer von 4,4 ns reflektieren. Durch den beispielhaften Streckungsfaktor von - 1ns/nm wird das Signal jedoch am ersten Gitter weitestgehend auf 2,2 ns und am zweiten Gitter in der Theorie auf das Transformations-Limit der Bandbreite von 3 ps komprimiert.

In **Figur 11b** ist ein beispielhaftes verstärktes VCSEL-Signal mit über 10 ns Dauer zu sehen. Nach dem ersten gechirpten Faser-Bragg-Gitter (CFBG) (105/106 Figur 8b) beträgt die Dauer des optischen Impulses noch 2,2 ns und weist einen linearen Chirp von 1000 ps/nm auf. Der optische Impuls besitzt nach Passieren des zweiten CFBG (105/106 **Figur 8b**) eine Impulsdauer von 3,5 ps und liegt somit unterhalb des Auflösungslimits des Abtast-Oszilloskops (Engl.: sampling oscilloscope). Die Dauer des optischen Impulses wird deshalb mittels einer interferometrischen Autokorrelation ermittelt.

Mit den Faser-Bragg-Gittern ist es beispielhaft gelungen, einen optischen Impuls, erzeugt mit einem elektrisch gepulsten VCSEL-Laser 1, um das mindestens 1200-fache zu komprimieren. Eine Impulsdauer von unter 3,5 ps kann derart beispielhaft erreicht werden, wobei der optische Impuls eine spektrale Bandbreite von 2 nm aufweist (3 ps ist das Transformationslimit bei einer zentralen Wellenlänge von 1550 nm).

Mittels eines reinen faserbäsierten Systems können optische Impulse mit Impulsenergien von etwa 10 nJ bei einer Dauer von etwa 3,5 ns erreicht werden, wenn ein elektrischer Impuls derart eingestellt ist, dass eine vollständige Kompression des optischen Impulses durch das gechirpte Faser-Bragg-Gitter erfolgt.

Wird eine elektrische Spannung so eingestellt, dass der optische Impuls nach dem Passieren eines gechirpten Faser-Bragg-Gitters noch eine Dauer von etwa 1 ns aufweist, so kann ein Hauptverstärker den optischen Impuls auf über 1 $\mu$J verstärken. Durch die große Verstärkung der Impulsenergie ist es in den meisten Fällen notwendig, dass der intensive optische Impuls nachfolgend beispielsweise auf 3,5 ps mittels eines Freistrahl-Kompressors optisch komprimiert wird.

**Bezugszeichenliste**

1. Diode / Oberflächenemitter / VCSEL-Diode
1a. Resonator
2. An der Laserdiode emittierter optischer Laserimpuls
3. Optisch aktives Medium
4. Elektrode
4'. Öffnung in Oberflächenemitter, durch die optische Impulse emittiert werden
5. (Substrat-)Elektrode
6. Transversales Modenfeld
6'. Longitudinales Modenfeld
7. Oberer Reflektor
7'. Bragg-Schichtung des oberen Reflektors
8. Unterer Reflektor
8'. Bragg-Schichtung des unteren Reflektors
9. Flussrichtung des elektrischen Stroms
10. Elektrischer Impuls
10a. (Vorzugsweise regelbarer) Elektronischer Pulsgenerator
11. Pulstrigger /Abschnitt der Schaltung zum Triggern des elektrischen Impulses / Abschnitt a
12. Abschnitt der Schaltung zur Kontrolle über die Impulsdauer / Abschnitt b
13. Abschnitt der Schaltung zum Erzeugen einer konstanten Spannung / Abschnitt c
14. Erster Verstärker / Abschnitt d
15. Zweiter Verstärker / Abschnitt e
16. Feinabstimmung (fine tuning) der Impulsform / Abschnitt f
17. Oberflächenemitter, der die optische Antwort generiert / Abschnitt g
18. Widerstand
19. Induktor / Spule
20. Kapazität
21. MOSFET / Metall-Oxid-Halbleiter-Feldeffekttransistor
22. Komparator
100. System
101. Diode / Oberflächenemitter / VCSEL-Diode
102. An dem System emittierter optischer Laserimpuls
103. Optisches Verstärkerelement / Vorverstärker
104. Optisches Verstärkerelement / Hauptverstärker
105. Kompressor(element) /Kompressionselement
106. Selektionselement
110. Stromstärke-Spannungslinie bei 20°C
120. Stromstärke-Spannungslinie bei 80°C
130. Stromstärke-Leistungslinie bei 20°C
140. Stromstärke-Leistungslinie bei 80°C
150. Zentralwellenlänge eines optischen Impulses in Abhängigkeit der Stromstärke bei 20°C
160. Zentralwellenlänge eines optischen Impulses in Abhängigkeit der Stromstärke bei 80°C
170. Zeitlichen Verlauf eines elektrischen Impulses, der eine Laserdiode erreicht
180. Zeitlichen Verlauf der Intensität eines optischen Impulses, der durch eine Laserdiode emittiert wird

200. Konventionelles Lasersystem zur Erzeugung (ultra-)kurzer optischer Impulse
201. Anregungslaser (Engl.: seed laser)
202. Anregungspuls
203. Optische Gitter
$203_1$. Zu Erst passiertes optisches Gitter
$203_2$. Als Zweites passiertes optisches Gitter
204. Spiegel mit vertikalem Versatz gegenüber einem Laserstrahl
205. Impulsstrecker (Engl.: stretcher)/zeitliche Impulsstreckung umfassend zwei Gitter
206. Impulskompressor (Engl.: compressor)/zeitliche Impulskompression umfassend zwei Gitter
207. Spiegel
$207_1$. Zuerst passierter Spiegel
$207_2$. Als Zweites passierter Spiegel
208. Verstärkermedium
209. Linse
210. Von einem konventionellen Lasersystem erzeugter Kurzimpuls
301. Beispielhaftes Spektrum eines optischen Impulses, der von einer Laserdiode emittiert wurde
302. Beispielhaftes Spektrum eines optischen Impulses, der von einer Laserdiode emittiert wurde und ein erstes und ein zweites Faser-Bragg Gitter passiert hat
303. Beispielhafter zeitlicher Verlauf eines optischen Impulses, der von einer Laserdiode emittiert wurde
304. Beispielhafter zeitlicher Verlauf eines optischen Impulses, der von einer Laserdiode emittiert wurde und ein erstes Faser-Bragg Gitter passiert hat
305. Beispielhafter zeitlicher Verlauf eines optischen Impulses, der von einer Laserdiode emittiert wurde und ein erstes und ein zweites Faser-Bragg Gitter passiert hat
D. Durchmesser des optisch aktiven Mediums
d. Schichtdicke des optisch aktiven Mediums
U. Spannung
I. Strom
L. Länge der Kavität

**Patentansprüche**

1. Verfahren zum Erzeugen eines optischen Impulses (2) mit einem vorbestimmten Chirp, umfassend:

   - Anlegen eines elektrischen Impulses (10) mit einer vorbestimmten Impulsdauer an eine Laserdiode (1), insbesondere einen Oberflächenemitter (1), VCSEL, so dass sich während der Impulsdauer des elektrischen Impulses (10) die Temperatur zumindest eines Bereichs eines Resonators der Laserdiode (4) verändert, wodurch sich während der Impulsdauer des elektrischen Impulses (10) ein Wellenlängenspektrum der von der Laserdiode (1) emittierten elektromagnetischen Strahlung (2) zeitlich ändert.

2. Verfahren nach Anspruch 1, wobei sich die Temperatur mindestens eines Spiegels, bevorzugt zweier Spiegel, insbesondere zweier Bragg-Schicht-Reflektoren des Resonators und/oder eines optisch aktiven Mediums zwischen zwei Spiegeln des Resonators verändert.

3. Verfahren nach Anspruch 1 oder 2, wobei sich die Temperatur eines Elements des Resonators derart ändert, dass sich eine optische Weglänge zwischen zwei Spiegeln des Resonators verändert.

4. Verfahren nach einem der vorangehenden Ansprüche, weiter umfassend die Schritte:

   - Selektion eines vorbestimmten spektralen Wellenlängenbereichs, der
   - während der Impulsdauer des elektrischen Impulses (10) von der Laserdiode (1) emittiert wird; und insbesondere Ausschluss eines Wellenlängenbereichs des Wellenlängenspektrums

   eines von der Laserdiode (1) emittierten optischen Impulses aus dem vorbestimmten selektierten Wellenlängenbereich, wobei der ausgeschlossene Wellenlängenbereich mindestens eine überhöhte Intensität aufweist, die wesentlich von den Intensitäten anderer Wellenlängen abweicht, bevorzugt betrifft der ausgeschlossene Wellenlängenbereich dabei einen Bereich kurzer Wellenlängen in dem von der Laserdiode (1) emittierten Wellenlängenspektrum.

5. Verfahren nach Anspruch 4, wobei die Selektion mittels eines gechirpten Faser-Bragg-Gitters erfolgt.

6. Verfahren nach einem der vorangehenden Ansprüche, wobei der Chirp des optischen Impulses (2) Werte zwischen +/- 50 ps/nm und +/- 5 ns/nm beträgt.

7. Verfahren nach einem der vorangehenden Ansprüche, wobei mittels des elektrischen Impulses (10) der Chirp des optischen Impulses (2) gesteuert und/oder geregelt wird.

8. Verfahren nach Anspruch 7, wobei mittels einer maximalen elektrischen Spannung (U) des elektrischen Impulses (10) und/oder mittels eines zeitlichen Verlaufs der elektrischen Spannung (U) des elektrischen Impulses (10) und/oder mittels der Impulsdauer des elektrischen Impulses (10) der Chirp des optischen Impulses (2) geregelt oder gesteuert wird.

9. Verfahren nach einem der vorangehenden Ansprüche, weiter umfassend den Schritt:

   - Verstärken des optischen Impulses (2) mittels eines Verstärkers (103, 104),

   wobei der optische Impuls (2) an optische Eigenschaften des Verstärkers (103, 104) angepasst ist; und/oder

   - Komprimieren des optischen Impulses (2) mittels eines Kompressors (105),

   wobei der optische Impuls (2) an optische Eigenschaften des Kompressors (105) angepasst ist.

10. Verfahren nach einem der vorangehenden Ansprüche, wobei Spannungswerte (U) und/oder Stromwerte (I) des elektrischen Impulses (10) größer sind, als für den Betrieb der Laserdiode (1) empfohlene Spannungswerte (U) und/oder Stromwerte (I).

11. Laserdiode (1, 101), insbesondere ein Oberflächenemitter, VCSEL, (1, 101) mit einem optisch aktiven Bereich umfassend ein optisch aktives Medium (3) und einen Resonator mit zwei Resonatorspiegeln, wobei die Laserdiode (1) dazu ausgelegt ist, durch Anlegen eines elektrischen Impulses (10) mit einer vorbestimmten Impulsdauer einen optischen Impuls (2) zu emittieren, wobei mittels des elektrischen Impulses (10) die Temperatur zumindest eines Abschnitts des optisch aktiven Bereichs der Laserdiode (1) während der Impulsdauer des elektrischen Impulses (10) veränderbar ist, wodurch sich während der Impulsdauer des elektrischen Impulses (2) ein Wellenlängenspektrum der von der Laserdiode (1) emittierbaren elektromagnetischen Strahlung zeitlich ändert.

12. Laserdiode (1, 101) nach Anspruch 11, wobei der optisch aktive Bereich dazu ausgelegt ist, dass

   - mindestens ein Teilbereich der Temperaturerhöhung einer vorwiegend linearen Abhängigkeit von einem zeitlichen Verlauf des elektrischen Impulses (10) unterliegt; und/oder
   - der Chirp einer vorwiegend linearen Abhängigkeit zwischen mindestens einem Teilbereich einer Wellenlänge des emittierten optischen Impulses (2) und dem zeitlichen Verlauf des elektrischen Impulses (10) unterliegt, und/oder,
   - mindestens ein Teilbereich der Wellenlänge der emittierten optische Impulse (2) einer vorwiegend linearen Abhängigkeit von einer Stromstärke eines impulsartigen elektrischen Stroms (I) unterliegt.

13. System (100) zur Erzeugung einer elektromagnetischen Impulsfolge (102) optischer Impulse mit elektrisch steuerbaren Parametern, insbesondere mit einem elektrisch steuerbaren Chirp, das System umfassend:

- die Laserdiode (1, 101) nach einem der Ansprüche 15 oder 16; und
- mindestens einen elektronischen Pulsgenerator (10a), welcher dazu ausgelegt ist, den steuerbaren und/oder regelbaren elektrischen Impuls (10) zu generieren; und
- mindestens ein optisches Selektorelement (103, 104) welches dazu ausgelegt ist, einen vorbestimmten spektralen Wellenlängenbereich des optischen Impulses, der während der Impulsdauer des elektrischen Impulses (10) von der Laserdiode (1) emittiert wird, zu selektieren.

14. System (100) nach Anspruch 13, wobei das Selektorelement ein Faser-Bragg-Gitter umfasst, und/oder das System (100) weiter umfasst:

- mindestens ein optisches Verstärkerelement (103, 104), vorzugsweise umfassend einen Erbium-dotierten Faserverstärker; und/oder
- mindestens ein Kompressorelement (105), vorzugsweise umfassend ein gechirptes Volumen-Bragg-Gitter, oder
- ein Element zur gleichzeitigen Selektion und Kompression, vorzugsweise ein gechirptes Faser-Bragg-Gitter.

15. Verwenden einer Laserdiode (1, 101) nach einem der Ansprüche 11 oder 12 zur Emission von optischen Impulsen (2) mit einem vorbestimmten Chirp, insbesondere als Anregungslaser (101) in einem Lasersystem (100).

Figur 1

## Figur 2

Figur 3a

| 11 | 12 | 13 | 14 | 15 | 16 | 17 |
|---|---|---|---|---|---|---|
| Trigger Bsp.: 200 kHz | Kontrolle Impuls-dauer | Erzeugung einer konstanten Spannung | 1.Verstärker | 2.Verstärker | Feineinstellung der Impulsform | Opt. Signal |

10a

a) 1.Komparator 22  5V ~1µs 5V

b) 20 18 ~15ns 5V

c) 2.Komparator 22  5V ~15ns 5V

d) 1.Mosfet 21  7,5V 2ns ~15ns 7V

e) 2.Mosfet 21  7,5V 1ns ~15ns 7V

f) 19 10 ~15ns 1ns 7V  Oszilloskop 18

g) VCSEL 1  Opt. Signal 2

Legende: Impulsdauer

Anstiegszeit ∏ Impulshöhe

Widerstand 18

Spule 19

Kondensator 20

## Figur 3b

Schwellenstrom

Rollover-Effekt
Leistungsabfall

## Figur 3c

Figur 3d

Figur 3e

Figur 4

Figur 5a

Figur 5b

Figur 5c

Figur 6

Elektrische
Impulserzeugung

Optische Antwort der VCSEL Diode

Zeitlich

Chirp

Diagramm a

Diagramm b

Diagramm c

Linearer chirp =$\Delta T/\Delta\lambda \sim$ 2ns/nm

Fein einstellbare elektrische
Impulsform bestimmt den Chirp

Diagramm d

Diagramm e

Figur 7a

Figur 7b

## Figur 7c

Figur 8a

## Figur 8b

— 10a

100

**VCSEL mit elektr. Impulsgenerator**

Impulsdauer
Temp. peltier

Spannung

VCSEL

— 101

Polarisationssteller

FIBERPRO PC1100

Isolator

Polarisations-teiler

2.CFBG SF=-1ns/nm

WDM 2

WDM 1

105/106

P3  P1

105/106

4-Port PM-Zirkulator

Er³⁺-dotierte Faser

Isolator P4  P2

1.CFBG SF=-1ns/nm

104

WDM 3

WDM 4

Kollimator

104

Er³⁺-dotierte Faser

Gechirptes Volumen-Bragg-Gitter SF: -100 ps/nm

104

Figur 9a

Figur 9b

FWHM = 2.15 nm

sim. CFBG: SF= -1003.4(1) ps/nm

FWHM = 2.16 nm

1. CFBG: SF = -1004.9(4) ps/nm
2. CFBG: SF =   -999.8(3) ps/nm

Figur 10

Figur 11a

Figur 11b

Europäisches Patentamt
European Patent Office
Office européen des brevets

# EUROPÄISCHER RECHERCHENBERICHT

Nummer der Anmeldung

EP 17 00 0826

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 9 236 707 B1 (DESBIENS LOUIS [CA]) 12. Januar 2016 (2016-01-12) * Spalte 3, Zeile 26 - Spalte 11, Zeile 20; Abbildungen 1-10 * * Spalte 13, Zeile 49 - Spalte 14, Zeile 36 * ----- | 1-15 | INV. H01S5/062 H01S5/00 H01S5/042 ADD. H01S5/06 H01S5/183 |
| X | MATEJ NJEGOVEC AND DENIS DONLAGIC: "Rapid and broad wavelength sweeping of standard telecommunication distributed feedback laser diode", OPTICS LETTERS, OPTICAL SOCIETY OF AMERICA, Bd. 38, Nr. 11, 1. Juni 2013 (2013-06-01), Seiten 1999-2001, XP001582963, ISSN: 0146-9592, DOI: HTTP://DX.DOI.ORG/10.1364/OL.38.001999 * Seite 1999, linke Spalte, Absatz 3 - Seite 2001, linke Spalte, Absatz 3; Abbildungen 2-6 * ----- | 1,2,4,5, 7,8, 10-13,15 | |
| X | BUCCAFUSCA O ET AL: "Transient Response of Vertical-Cavity Surface-Emitting Lasers of Different Active-Region Diameters", IEEE JOURNAL OF QUANTUM ELECTRONICS, IEEE SERVICE CENTER, PISCATAWAY, NJ, USA, Bd. 35, Nr. 4, 1. April 1999 (1999-04-01), XP011052171, ISSN: 0018-9197 * Seite 608, rechte Spalte, Absatz 3 - Seite 611, rechte Spalte, Absatz 1; Abbildungen 1-4 * ----- | 1-4,7,8, 10,11 | RECHERCHIERTE SACHGEBIETE (IPC) H01S |
| X | US 2009/067459 A1 (MIZUUCHI KIMINORI [JP] ET AL) 12. März 2009 (2009-03-12) * Absätze [0031] - [0053], [0062] - [0065]; Abbildungen 1-5,10 * ----- | 1,3-5,7, 11,13,15 | |

Der vorliegende Recherchenbericht wurde für alle Patentansprüche erstellt

| Recherchenort | Abschlußdatum der Recherche | Prüfer |
|---|---|---|
| München | 14. November 2017 | Laenen, Robert |

## ANHANG ZUM EUROPÄISCHEN RECHERCHENBERICHT
## ÜBER DIE EUROPÄISCHE PATENTANMELDUNG NR.

EP 17 00 0826

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-11-2017

| Im Recherchenbericht angeführtes Patentdokument | Datum der Veröffentlichung | Mitglied(er) der Patentfamilie | Datum der Veröffentlichung |
|---|---|---|---|
| US 9236707 B1 | 12-01-2016 | KEINE | |
| US 2009067459 A1 | 12-03-2009 | CN 101395772 A | 25-03-2009 |
| | | JP 5231990 B2 | 10-07-2013 |
| | | JP WO2007099847 A1 | 16-07-2009 |
| | | US 2009067459 A1 | 12-03-2009 |
| | | WO 2007099847 A1 | 07-09-2007 |

Für nähere Einzelheiten zu diesem Anhang : siehe Amtsblatt des Europäischen Patentamts, Nr.12/82

EPO FORM P0461